(19) Europäisches Patentamt
European Patent Office
Office européen des brevets

(11) EP 3 447 813 A1

(12) **EUROPEAN PATENT APPLICATION**
published in accordance with Art. 153(4) EPC

(43) Date of publication:
**27.02.2019 Bulletin 2019/09**

(21) Application number: **17785873.5**

(22) Date of filing: **12.04.2017**

(51) Int Cl.:
***H01L 51/05*** *(2006.01)* ***G01N 27/414*** *(2006.01)*
***H01L 51/30*** *(2006.01)*

(86) International application number:
**PCT/JP2017/014961**

(87) International publication number:
**WO 2017/183534 (26.10.2017 Gazette 2017/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **19.04.2016 JP 2016083356**

(71) Applicant: **Toray Industries, Inc.**
**Tokyo 103-8666 (JP)**

(72) Inventors:
- **ISOGAI, Kazuki**
  **Otsu-shi**
  **Shiga 520-8558 (JP)**
- **MURASE, Seiichiro**
  **Otsu-shi**
  **Shiga 520-8558 (JP)**
- **NAGAO, Kazumasa**
  **Otsu-shi**
  **Shiga 520-8558 (JP)**

(74) Representative: **Hoefer & Partner Patentanwälte mbB**
**Pilgersheimer Straße 20**
**81543 München (DE)**

# (54) SEMICONDUCTOR ELEMENT, METHOD FOR MANUFACTURING SAME, WIRELESS COMMUNICATION DEVICE, AND SENSOR

(57) A semiconductor element including a substrate, a first electrode, a second electrode, and a semiconductor layer disposed between the first electrode and the second electrode, wherein the semiconductor layer contains at least one selected from carbon nanotubes and graphene, and a relationship between a channel length $L_C$ and a channel width $W_C$ of the semiconductor element is $0.01 \leq W_C/L_C \leq 0.8$. A semiconductor element having excellent switching characteristics and high detection sensitivity when used as a sensor is provided.

Fig. 1A

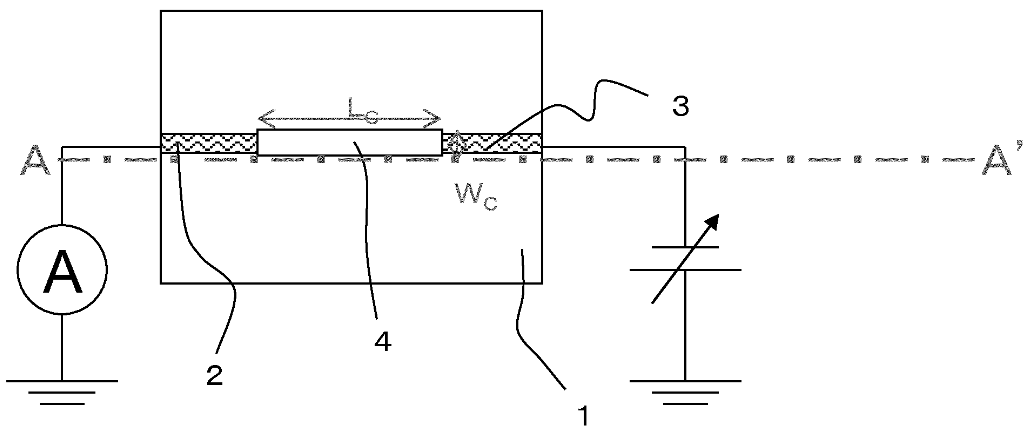


EP 3 447 813 A1

## Description

TECHNICAL FIELD

The present invention relates to a semiconductor element, a method for manufacturing the same, as well as a wireless communication device and a sensor including the semiconductor element.

BACKGROUND ART

Semiconductor elements such as transistors, memories, and capacitors are used in various electronic devices such as displays and computers utilizing their semiconductor characteristics. For example, IC tags and sensors that utilize electric characteristics of a field effect transistor (hereinafter referred to as a FET) have been developed.

In recent years, for IC tags, a wireless communication system utilizing a RFID (Radio Frequency IDentification) technique has been developed for use as a contactless-type tag. In the RFID system, wireless communication is performed between a wireless transceiver called a reader/writer and a RFID tag. The RFID tag is expected to be used for various applications such as physical distribution management, product management, and shoplifting prevention, and has been introduced in some applications such as applications in IC cards including traffic cards, and product tags. The RFID tag has an IC chip and an antenna. The antenna installed in the RFID tag receives a carrier wave transmitted from the reader/writer, and a drive circuit in the IC chip operates.

As a sensor, a FET type biosensor, which detects biological reactions using a FET, has been actively researched from the viewpoint that labeling with a fluorescent substance or the like is unnecessary, electrical signal conversion is fast, and connection with an integrated circuit is easy. Conventionally, as a biosensor including a FET, a sensor called an ion sensitive FET sensor is known, which has a structure in which a gate electrode is removed from a metal-oxide-semiconductor (MOS) FET and an ion sensitive membrane is deposited on an insulating film. The sensor is designed to function as various biosensors owing to a biomolecule recognition substance disposed on an ion sensitive membrane.

As semiconductor elements used for these applications, inorganic semiconductors such as silicon are mainstream. However, the manufacturing process of the inorganic semiconductor elements requires expensive manufacturing equipment and is conducted under vacuum and/or at high temperatures, and thus, cost reduction is difficult. Therefore, a flexible and inexpensive manufacturing process of semiconductor elements in which a coating/printing technique is used has been studied. A FET in which carbon nanotubes (CNTs) having high mechanical and electric characteristics are used as a material of a semiconductor layer suitable for the coating/printing technique instead of conventional inorganic semiconductor elements has been actively studied (see, for example, Patent Documents 1 to 3 and Non-Patent Documents 1 and 2). In the above-mentioned documents, semiconductor elements in which one string of CNT and a CNT network are used as a semiconductor layer are disclosed.

PRIOR ART DOCUMENTS

PATENT DOCUMENTS

Patent Document 1: International Publication No. 2009/139339
Patent Document 2: Japanese Patent Laid-open Publication No. 2012-163578
Patent Document 3: International Publication No. 2015/012186

NON-PATENT DOCUMENTS

Non-Patent Document 1: ANALYTICAL CHEMISTRY 2007 VOL. 79 782-787
Non-Patent Document 2: ACS NANO 2010 VOL. 4 No. 11 6914-6922

SUMMARY OF THE INVENTION

PROBLEMS TO BE SOLVED BY THE INVENTION

High switching characteristics are required of semiconductor elements used for IC tags and sensors. Switching characteristics are a difference between an on-state current and an off-state current of a semiconductor element, and

a semiconductor element in which a high on-state current is obtained at a low off-state current is a semiconductor element having high switching characteristics. In the techniques described in Non-Patent Documents 1 and 2, obtaining high switching characteristics is difficult.

Further, in the technique disclosed in Non-Patent Document 1, when the semiconductor element is used as a sensor, the current in the channel is small and a sufficient signal to noise ratio is not achieved. In the techniques described in Patent Documents 2 to 3, detection sensitivity is limited.

In view of the above-mentioned problems, an object of the present invention is to provide a semiconductor element having excellent switching characteristics and high detection sensitivity when used as a sensor.

SOLUTIONS TO THE PROBLEMS

In order to solve the above-mentioned problems, the present invention has the following constitution. That is, the present invention is a semiconductor element including a substrate, a first electrode, a second electrode, and a semiconductor layer disposed between the first electrode and the second electrode, wherein the semiconductor layer contains at least one selected from carbon nanotubes and graphene, and a relationship between a channel length $L_C$ and a channel width $W_C$ of the semiconductor element is $0.01 \leq W_C/L_C \leq 0.8$.

The present invention includes a wireless communication device including at least the above-mentioned semiconductor element and an antenna.

The present invention includes a sensor including the semiconductor element.

The present invention includes a method for manufacturing the semiconductor element, the method including the step of applying and drying a solution containing carbon nanotubes to form the semiconductor layer.

EFFECTS OF THE INVENTION

According to the present invention, a semiconductor element having excellent switching characteristics, a wireless communication device including the semiconductor element, and a sensor having high detection sensitivity can be provided.

BRIEF DESCRIPTION OF THE DRAWINGS

Fig. 1A is a schematic plan view showing an example of the semiconductor element of the present invention.
Fig. 1B is a schematic sectional view showing an example of the semiconductor element of the present invention.
Fig. 2 is a schematic plan view showing an example of the semiconductor element of the present invention.
Fig. 3 is a schematic sectional view showing an example of the semiconductor element of the present invention.
Fig. 4 is a schematic plan view showing an example of the semiconductor element of the present invention.
Fig. 5 is a graph showing values of a current flowing between the first electrode and the second electrode when BSA, IgE, and avidin are added to the semiconductor layer of the semiconductor element shown in Example 1 of the present invention.
Fig. 6 is a schematic plan view showing an example of the semiconductor element of the present invention.
Fig. 7A is a schematic plan view showing an example of the semiconductor element of the present invention.
Fig. 7B is a schematic sectional view showing an example of the semiconductor element of the present invention.
Fig. 8 is a schematic plan view showing an example of the semiconductor element of the present invention.
Fig. 9 is a block diagram showing an example of a wireless communication device including the semiconductor element of the present invention.

EMBODIMENTS OF THE INVENTION

<Semiconductor Element>

The semiconductor element of the present invention is a semiconductor element including a substrate, a first electrode, a second electrode, and a semiconductor layer disposed between the first electrode and the second electrode, wherein the semiconductor layer contains at least one selected from carbon nanotubes and graphene, and a relationship between a channel length $L_C$ and a channel width $W_C$ of the semiconductor element is $0.01 \leq W_C/L_C \leq 0.8$.

Fig. 1A is a schematic plan view showing an example of the semiconductor element of the present invention. Fig. 1B is a sectional view of the semiconductor element shown in Fig. 1A cut along a line AA'. In the semiconductor element in Fig. 1, a first electrode 2 and a second electrode 3 are formed on a substrate 1, and a semiconductor layer

4 is disposed between the first electrode 2 and the second electrode 3.

Fig. 2 is a schematic plan view showing another example of the semiconductor element of the present invention. The disposition of the first electrode 2, the second electrode 3, and the semiconductor layer 4 is different from that in Fig. 1.

The channel length ($L_C$) and the channel width ($W_C$) in the present invention are the length and the width of the region that functions as a channel in the semiconductor layer, respectively. Examples of $L_C$ and $W_C$ are shown in Figs. 1A and 2.

The semiconductor element of the present invention has a relationship between $L_C$ and $W_C$ of $0.01 \leq W_C/L_C \leq 0.8$, and thus provides good switching characteristics when used as a FET.

When the semiconductor layer contains CNTs, the CNTs form a three-dimensional conductive path by forming a network. CNTs are known to be a mixture of metallic CNTs and semiconducting CNTs, and the above-mentioned three-dimensional conductive path contains both metallic CNTs and semiconducting CNTs.

When the relationship between $W_C$ and $L_C$ is $W_C/L_C > 0.8$, the channel width is too large relative to the channel length, and thus the first electrode and the second electrode are highly likely to short-circuit due to the conductive path between the metallic CNTs. When the first electrode and the second electrode short-circuit, a low off-state current and a high on-state current are not simultaneously achieved, and thus good switching characteristics are not obtained. On the other hand, when the relationship between $W_C$ and $L_C$ is $W_C/L_C \leq 0.8$, the channel width is too narrow relative to the channel length, and thus the first electrode and the second electrode are less likely to short-circuit due to the conductive path between the metallic CNTs. Therefore, a low off-state current and a high on-state current are simultaneously achieved, and good switching characteristics are obtained. It is believed that such a mechanism realizes good switching characteristics.

The upper limit of $W_C/L_C$ is 0.8, preferably 0.5.

The lower limit of $W_C/L_C$ is 0.01, preferably 0.1. When $W_C/L_C$ is in this range, a sufficient amount of current flows in the semiconductor element and the on-state current can be increased.

The sizes of the channel width and the channel length are not particularly limited, but are preferably in the range of 1 μm to 10 mm. Examples of the preferred relationship between the channel length and the channel width include a channel width of 4 μm and a channel length of 5 μm to 400 μm, a channel width of 100 μm and a channel length of 150 μm to 2 mm, a channel width of 200 μm and a channel length of 300 μm to 4 mm, a channel width of 500 μm and a channel length of 700 μm to 8 mm, and a channel width of 1 mm and a channel length of 1.5 mm to 10 mm.

In particular, the channel width is more preferably 1 μm or more, further preferably 2 μm or more, still more preferably 4 μm or more. The channel width is more preferably 2 mm or less, further preferably 1 mm or less, still more preferably 300 μm or less. The channel length is more preferably 1.3 μm or more, further preferably 2.5 μm or more, still more preferably 5 μm or more. The channel length is more preferably 2.5 mm or less, further preferably 1.25 mm or less, still more preferably 375 μm or less. The channel length is particularly preferably 5 μm to 30 μm. Within this range, good switching characteristics are obtained by a mechanism to be described later, and when the semiconductor element is used as an integrated circuit, the element size can be reduced and the integration degree can be increased.

The disposition of the first electrode and the second electrode is arbitrarily selected as long as the channel width and the channel length satisfy the above-mentioned relationship. Examples of the disposition include, but are not limited to, the dispositions shown in Figs. 1 and 2.

Another aspect of the semiconductor element of the present invention is an aspect in which the semiconductor element further includes a gate electrode and an insulating layer, and the gate electrode is disposed electrically insulated from the first electrode, the second electrode, and the semiconductor layer by the insulating layer.

In the semiconductor element in Fig. 3, a gate electrode 5 and an insulating layer 6 are formed on a substrate 1, and a first electrode 2 and a second electrode 3 are formed thereon, and a semiconductor layer 4 is disposed between the first electrode 2 and the second electrode 3. In the semiconductor element in Fig. 3, the first electrode 2 and the second electrode 3 correspond to a source electrode and a drain electrode, respectively, and the insulating layer 6 corresponds to a gate insulating layer. Thus, the semiconductor element functions as a FET and a thin film transistor.

In the semiconductor element in Fig. 4, a first electrode 2, a second electrode 3, and a gate electrode 5 are formed on a substrate 1, and a semiconductor layer 4 is disposed between the first electrode 2 and the second electrode 3. In the semiconductor element in Fig. 4, the first electrode 2 and the second electrode 3 correspond to a source electrode and a drain electrode, respectively. When an aqueous solution or the like is disposed so as to cover the semiconductor layer 4 and the gate electrode 5, the aqueous solution or the like functions as a gate insulating layer. Thus, the semiconductor element functions as a FET and a thin film transistor.

A preferred aspect of the semiconductor element of the present invention is an aspect in which the semiconductor element includes a plurality of the above-mentioned semiconductor elements, the first electrodes in the plurality of semiconductor elements are electrically connected to each other, and the second electrodes therein are electrically connected to each other. In such an aspect, the semiconductor element includes a plurality of semiconductor layers in one semiconductor element, but is considered to be electrically one semiconductor element. Hereinafter, in such an aspect, each semiconductor element of the plurality of semiconductor elements that constitute the element is referred

to as a discrete semiconductor element. With this constitution, a high on-state current can be obtained with the off-state current being kept low, and thus better switching characteristics are obtained. Fig. 6 is a schematic plan view showing an example of the semiconductor element of this aspect. In a semiconductor element 30, a discrete semiconductor element 10 and a discrete semiconductor element 20 are formed on a substrate 1. The discrete semiconductor element 10 includes a first electrode 12, a second electrode 13, and a semiconductor layer 14, and the semiconductor layer 14 is disposed between the first electrode 12 and the second electrode 13. Similarly, the discrete semiconductor element 20 includes a first electrode 22, a second electrode 23, and a semiconductor layer 24, and the semiconductor layer 24 is disposed between the first electrode 22 and the second electrode 23. The first electrode 12 of the discrete semiconductor element 10 and the first electrode 22 of the discrete semiconductor element 20 are electrically connected by an electrode 32, and the second electrode 13 of the discrete semiconductor element 10 and the second electrode 23 of the discrete semiconductor element 20 are electrically connected by an electrode 33.

Another aspect of the semiconductor element of the present invention is a semiconductor element including a plurality of discrete semiconductor elements, and further including a third electrode and an insulating layer, wherein the first electrodes in the plurality of discrete semiconductor elements are electrically connected to each other and the second electrodes in the plurality of discrete semiconductor elements are electrically connected to each other, and the third electrode is disposed electrically insulated from the first electrodes in the plurality of discrete semiconductor elements, the second electrodes in the plurality of discrete semiconductor elements, and the semiconductor layers in the plurality of discrete semiconductor elements by the insulating layer.

Fig. 7A is a schematic plan view showing an example of the semiconductor element of this aspect, and Fig. 7B is a sectional view of the semiconductor element shown in Fig. 7A cut along a line BB'. A gate electrode 5 and an insulating layer 6 are formed on a substrate 1, and a discrete semiconductor element 10 and a discrete semiconductor element 20 are formed thereon. The discrete semiconductor element 10 includes a first electrode 12, a second electrode 13, and a semiconductor layer 14, and the semiconductor layer 14 is disposed between the first electrode 12 and the second electrode 13. Similarly, the discrete semiconductor element 20 includes a first electrode 22, a second electrode 23, and a semiconductor layer 24, and the semiconductor layer 24 is disposed between the first electrode 22 and the second electrode 23. The first electrode 12 of the discrete semiconductor element 10 and the first electrode 22 of the discrete semiconductor element 20 are electrically connected by an electrode 32, and the second electrode 13 of the discrete semiconductor element 10 and the second electrode 23 of the discrete semiconductor element 20 are electrically connected by an electrode 33. In the semiconductor elements in Figs. 7A and 7B, the first electrodes 12, 22, and 32 and the second electrodes 13, 23, and 33 correspond to the source electrodes and the drain electrodes, respectively, and the insulating layer 6 corresponds to the gate insulating layer. Thus, the semiconductor elements function as a FET and a thin film transistor.

In addition to the disposition of the semiconductor element in Fig. 6, the semiconductor element in Fig. 8 has a gate electrode 5 formed on a substrate 1. In the semiconductor element in Fig. 8, first electrodes 12, 22, and 32, and second electrodes 13, 23, and 33 correspond to the source electrodes and the drain electrodes, respectively, and when an aqueous solution or the like is disposed so as to cover the semiconductor layer 4 and the gate electrode 5, the aqueous solution or the like functions as a gate insulating layer. Thus, the semiconductor element functions as a FET and a thin film transistor.

When the semiconductor element of the present invention includes a plurality of discrete semiconductor elements, the number of the discrete semiconductor elements included is not particularly limited, but is preferably 3 or more, more preferably 5 or more. Within this range, a high on-state current can be obtained. The upper limit of the number of semiconductor elements included in the semiconductor element of the present invention is not particularly limited, but is preferably 100 or less, more preferably 50 or less. Within this range, the off-state current can be kept low.

Examples of the material used for the substrate include inorganic materials such as a silicon wafer, glass, and an alumina sintered body; organic materials such as polyimide, polyester, polycarbonate, polysulfone, polyethersulfone, polyethylene, polyphenylene sulfide, polyparaxylene, polyimide, polyvinyl alcohol, polyvinyl chloride, polyethylene terephthalate, polyvinylidene fluoride, polysiloxane, and polyvinyl phenol; and a mixture of an inorganic material powder and an organic material. These materials may be used alone, or two or more of them may be used as a laminate or a mixture. A polysiloxane layer is preferably formed on the substrate. The polysiloxane layer is effective for surface flatness and surface flattening, and contributes to the reduction of irregularities on the substrate surface. Due to the polysiloxane layer formed on the substrate, irregularities on the substrate surface are reduced and a semiconductor layer can be formed without impairing the conductivity of the three-dimensional conductive path formed by the CNT network.

The arithmetic mean roughness (Ra) of the substrate surface between the first electrode and the second electrode is preferably 2 nm or less. When the arithmetic mean roughness (Ra) of the substrate surface is in this range, irregularities on the substrate surface are small, and thus a semiconductor layer can be formed without impairing the conductivity of the three-dimensional conductive path formed by the CNT network. The arithmetic mean roughness (Ra) is a value obtained by observing the cross section of the substrate between the first electrode and the second electrode using a scanning electron microscope (SEM) or a transmission electron microscope (TEM), calculating the arithmetic

mean roughness (Ra) of the 10 points selected randomly from the obtained image, and averaging these Ra values. A SEM or a TEM can be selected depending on the degree of surface roughness. When the surface irregularities are 50 nm or more, a SEM is used, and when the surface irregularities are less than 50 nm, a TEM is used. The arithmetic mean roughness (Ra) is a value obtained by extracting a curve corresponding to a reference length from a roughness curve in a direction of the average line, summing the absolute values of the deviations from the average line to the measurement curve of the extracted portion, and averaging the sum. The reference length is 1 μm. When another layer such as an insulating layer is provided between the substrate and the first and second electrodes, the arithmetic mean roughness (Ra) of the substrate surface between the first electrode and the second electrode refers to the arithmetic mean roughness (Ra) of the surface of the other layer. For example, when the polysiloxane layer is formed on the substrate, the arithmetic mean roughness (Ra) of the substrate surface between the first electrode and the second electrode is the arithmetic mean roughness (Ra) of the surface of the polysiloxane layer between the first electrode and the second electrode.

The material used for the insulating layer 6 is not particularly limited, and specific examples of the material include inorganic materials such as silicon oxide and alumina; and organic high-molecular-weight materials such as polyimide, polyvinyl alcohol, polyvinyl chloride, polyethylene terephthalate, polyvinylidene fluoride, polysiloxane and polyvinylphenol (PVP). Among these, those containing an organic compound containing a bond between silicon and carbon are preferred, and specifically polysiloxane is preferred. Further, the insulating layer preferably contains a metallic compound in addition to the above-mentioned organic compounds. As the metallic compound, a metallic compound containing a bond between a metal atom and an oxygen atom is preferred. Examples of the metallic compound include metal oxides and metal hydroxides. The metal atom contained in the metallic compound is not particularly limited as long as it forms a metal chelate. Examples of the metal atom include magnesium, aluminum, titanium, chromium, manganese, cobalt, nickel, copper, zinc, gallium, zirconium, ruthenium, palladium, indium, hafnium, and platinum. Among these, aluminum is preferred from the viewpoint of the availability, cost, and stability of the metal chelate.

In an aspect in which the semiconductor element includes a third electrode and an insulating layer on the substrate, the polysiloxane layer provided on the substrate may be used as the insulating layer. As described above, polysiloxane is effective for surface flatness and surface flattening, and thus contributes to the reduction of irregularities on the surface of the insulating layer. By reducing the irregularities on the surface of the insulating layer, a semiconductor layer can be formed without impairing the conductivity of the three-dimensional conductive path formed by the CNT network.

The insulating layer may be a single layer or multiple layers, or a single layer may be formed from multiple insulating materials, or multiple insulating layers may be formed by laminating multiple insulating materials. The thickness of the insulating layer is preferably 0.05 to 5 μm, more preferably 0.1 to 1 μm. When the thickness falls within this range, a uniform thin film can be easily formed. The thickness can be determined, for example, with an atomic force microscope or by an ellipsometric method.

The method for producing the insulating layer is not particularly limited, and examples of the method include a method in which a material that constitutes the insulating layer or a composition containing a precursor or a monomer of the material is applied to a substrate and then dried, and the obtained coating film is heat-treated as needed. Examples of the method for the application include known coating methods, such as a spin coating method, a blade coating method, a slit die coating method, a screen printing method, a bar coater method, a template method, a print transfer method, a dipping-withdrawing method, and an inkjet method. The temperature for the heat treatment of the coating film is preferably in the range of 100 to 300°C.

Specific examples of the materials used for the first electrode 2, the second electrode 3, and the gate electrode 5 include, but are not limited to, conductive metal oxides such as tin oxide, indium oxide and indium tin oxide (ITO); metals such as platinum, gold, silver, copper, iron, tin, zinc, aluminum, indium, chromium, lithium, sodium, potassium, cesium, calcium, magnesium, palladium, molybdenum, amorphous silicon, and polysilicon, and alloys of these metals; inorganic conductive substances such as copper iodide and copper sulfide; organic conductive substances such as polythiophene, polypyrrole, polyaniline, and a complex of polyethylenedioxythiophene and polystyrene sulfonate; and nano-carbon materials such as carbon nanotubes and graphene. These electrode materials may be used alone, or two or more of them may be used as a laminate or a mixture. When the semiconductor element is used as a sensor, the materials of the first electrode 2 and the second electrode 3 are preferably selected from gold, platinum, palladium, organic conductive materials, and nano-carbon materials from the viewpoint of stability to an aqueous solution in contact with the electrodes.

The width and thickness of the first electrode, the second electrode, and the gate electrode 5 are arbitrarily selected. The width is preferably in the range of 1 μm to 1 mm, and the thickness is preferably in the range of 1 nm to 1 μm. Examples of the width and thickness include, but are not limited to, a first electrode and a second electrode having a width of 100 μm and a thickness of 50 nm and a gate electrode having a width of 100 μm and a thickness of 50 nm disposed further thereon.

In a FET, the current flowing between a source electrode and a drain electrode can be controlled by changing

the gate voltage. The mobility of the FET can be calculated using the following formula (a).

$$\mu = (\delta Id/\delta Vg) L\cdot D/(W\cdot\varepsilon_r\cdot\varepsilon\cdot Vsd) \qquad (a)$$

where Id is the current between the source and the drain, Vsd is the voltage between the source and the drain, Vg is the gate voltage, D is the thickness of the insulating layer, L is the channel length, W is the channel width, $\varepsilon_r$ is the relative dielectric constant of the gate insulating layer, $\varepsilon$ is the dielectric constant of vacuum ($8.85 \times 10^{-12}$ F/m), and $\delta$ is the change amount of the corresponding physical quantity.

The on/off ratio can be obtained from the ratio of the maximum value of Id to the minimum value of Id.

(Semiconductor Layer)

In the semiconductor element of the present invention, the semiconductor layer contains at least one selected from CNTs and graphene, and thus good switching characteristics can be obtained. More preferably, the semiconductor layer contains CNTs.

Examples of the graphene include single layer graphene, multilayer graphene, graphene oxide, and graphene nanoribbon.

The CNTs to be used may be single-walled CNTs having a structure such that a single carbon membrane (a graphene sheet) is wound in a cylindrical form, two-walled CNTs having a structure such that two graphene sheets are wound concentrically, or multi-walled CNTs having a structure such that multiple graphene sheets are wound concentrically. From the viewpoint of achieving high semiconductor properties, single-walled CNTs are preferably used. The CNTs can be produced by an arc discharge method, a chemical vapor deposition method (a CVD method), a pulsed-laser deposition method or the like.

Preferably, the content of the semiconducting CNTs in the CNTs is 90% by weight or more and 99.5% by weight or less, that is, the content of the metallic CNTs in the CNTs is 0.5% by weight or more and 10% by weight or less. When the content of the metallic CNTs is in this range, the first electrode and the second electrode are less likely to short-circuit due to the conductive path between the metallic CNTs, and a high on-state current is obtained utilizing the high conductivity of the metallic CNTs. Thus, good switching characteristics are obtained.

As the method for obtaining CNTs having a content of semiconducting CNTs of 90% by weight or more, known methods can be employed. For example, the following methods can be mentioned: a method in which ultracentrifugation is carried out in the co-presence of a density-grading agent; a method in which a specific compound is attached to the surfaces of semiconducting or metallic CNTs selectively and desired CNTs are separated utilizing the difference in solubility; and a method in which desired CNTs are separated by electrophoresis or the like utilizing the difference in electric characteristics. Examples of the method for measuring the content of semiconducting CNTs include: a method in which the content is calculated from an absorption area ratio of visible-near-infrared absorption spectra; and a method in which the content is calculated from a ratio of intensities of Raman spectra.

The relationship between the length $L_{CNT}$ of the CNTs and the channel length $L_C$ is preferably $5 \le L_C/L_{CNT}$. When $L_C/L_{CNT}$ falls within this range, good switching characteristics can be obtained by the mechanism described below.

The length ($L_{CNT}$) of the CNTs refers to the average value of the lengths of 20 CNTs picked up at random. Examples of the method for measuring $L_{CNT}$ include a method of randomly picking up 20 CNTs from an image obtained by an atomic force microscope and obtaining an average value of their lengths.

As described above, in the semiconductor layer, the CNTs form a three-dimensional conductive path by forming a network, and the conductive path contains both the metallic CNTs and the semiconducting CNTs.

When $L_C/L_{CNT} < 5$, the CNTs are relatively long relative to the channel length, and thus the first electrode and the second electrode are highly likely to short-circuit due to the conductive path between the metallic CNTs. Therefore, a low off-state current and a high on-state current are not simultaneously achieved, and good switching characteristics are not obtained. On the other hand, when $5 \le L_C/L_{CNT}$, the CNTs are sufficiently short relative to the channel length, and thus the first electrode and the second electrode are less likely to short-circuit due to the conductive path between the metallic CNTs. Therefore, a low off-state current and a high on-state current are simultaneously achieved, and good switching characteristics are obtained. It is believed that such a mechanism realizes good switching characteristics. More preferably, $50 \le L_C/L_{CNT}$, still more preferably, $100 \le L_C/L_{CNT}$. The upper limit of $L_C/L_{CNT}$ is not particularly limited, however, $L_C/L_{CNT}$ is preferably less than 50,000.

Specifically, $L_{CNT}$ is preferably 2 $\mu$m or less, more preferably 1 $\mu$m or less.

The length of commercially available CNTs is distributed, and thus, a step of shortening the length of the CNTs is preferably performed so that the length of the CNTs satisfies the above-mentioned conditions. As the step of shortening

the length of the CNTs, methods such as a treatment with acids such as nitric acid and sulfuric acid, an ultrasonic treatment, and a freezing pulverization process are effectively used.

The diameter of the CNTs is not particularly limited, and is preferably 1 nm or more and 100 nm or less, more preferably 50 nm or less.

A step of dispersing CNTs in a solvent uniformly and filtering the resulting dispersion through a filter is preferably provided from the viewpoint of improving the purity. It becomes possible to efficiently obtain shorter CNTs than the distance between electrodes by obtaining shorter CNTs than the pore size of the filter from a filtrate. In this case, a membrane filter is preferably used as the filter. The pore size of the filter used for the filtration is preferably 0.5 to 10 $\mu$m.

As the CNTs contained in the semiconductor layer, CNT composites in which a polymer is attached to at least a part of a surface of CNTs are preferred. The CNT composites are configured such that the polymer is attached to at least a part of the surface of CNTs. Therefore, it becomes possible to uniformly disperse the CNTs in a solution without impairing the high electric characteristics of the CNTs. A CNT film having CNTs uniformly dispersed therein can be formed by a coating method from a solution having CNTs uniformly dispersed therein. In this manner, high semiconductor properties can be achieved.

The state where a polymer is attached to at least a part of the surface of CNTs refers to a state where a part or the whole of the surface of the CNTs is coated with the polymer.

It is presumed that the polymer can coat CNTs due to a hydrophobic interaction between the polymer and CNTs. When the polymer has a conjugated structure, it is presumed that the polymer can coat CNTs because interaction occurs as a result of overlapping of $\pi$ electron clouds derived from the conjugated structures of the polymer and CNTs.

When CNTs are coated with a polymer, the reflected color of the CNTs approaches the color of the polymer from the color of the uncoated CNTs. By observation of the color, whether the CNTs are coated or not can be judged. As a quantitative manner, the presence of an attached matter is confirmed and the ratio of the weight of the attached matter to the weight of the CNTs can be measured by an elementary analysis such as X-ray photoelectron spectroscopy (XPS).

Examples of the method for attaching a polymer to CNTs include: (I) a method in which CNTs are added to and mixed with a melted polymer; (II) a method in which a polymer is dissolved in a solvent and then CNTs are added to and mixed with the resulting solution; (III) a method in which CNTs are dispersed previously in a solvent with ultrasonic waves or the like and then a polymer is added to and mixed with the resulting solution; and (IV) a method in which a polymer and CNTs are added to a solvent and then ultrasonic waves are applied to the resulting mixed system to mix the system. In the present invention, any one of the above-mentioned methods may be employed, or two or more of the methods may be employed in combination.

Examples of the polymer include, but are not particularly limited to, celluloses such as cellulose and carboxymethylcellulose; acrylic resins such as polyhydroxymethyl methacrylate; polyalkylene glycols such as polyacrylic acid, alginic acid, sodium alginate, polyvinylsulfonic acid, sodium polyvinylsulfonate, polystyrenesulfonic acid, sodium polystyrenesulfonate, polyvinyl alcohol, and polyethylene glycol, polythiophene polymers such as poly-3-hexylthiophene, polypyrrole polymers, polyaniline polymers, polyacetylene polymers, poly-p-phenylene polymers, and poly-p-phenylene vinylene polymers. The above-mentioned polymers may be used alone or two or more of them may be used. Though a polymer in which a single type of monomer units lie on a line is preferably used, a polymer obtained by block copolymerization or random copolymerization of different monomer units can also be used. A polymer obtained by graft polymerization can also be used.

From the viewpoint of interaction with CNTs, a conjugated polymer is particularly preferred. When a conjugated polymer is used, CNTs can be uniformly dispersed in a solution without impairing the high electric characteristics of CNTs, and higher semiconductor properties can be realized.

The conjugated polymer does not necessarily have high molecular weight, and may be an oligomer composed of a linear conjugated system. A preferred molecular weight of the conjugated polymer is 800 to 100,000 in terms of number average molecular weight.

Examples of the conjugated polymer having the above-mentioned structure include polymers having the following structures. n in the structures represents the number of repetitions, and is in the range of 2 to 1000. The conjugated polymer may be a homopolymer of each structure or may be a copolymer.

[Chemical formula 1]

(1)
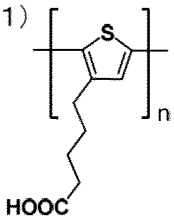
(2)
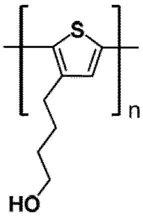
(3)
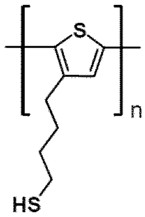
(4)
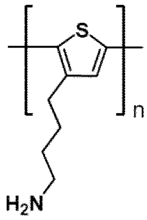

(5)
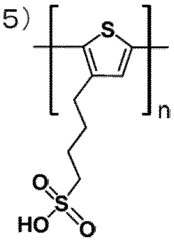
(6)
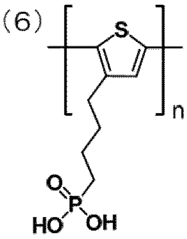
(7)
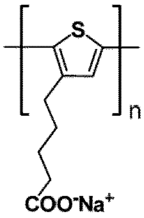
(8)
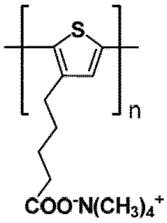

(9)
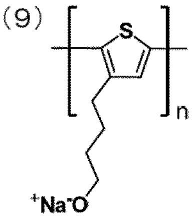
(10)
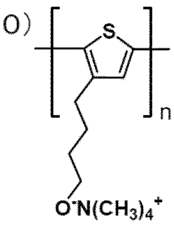
(11)
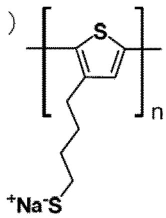
(12)
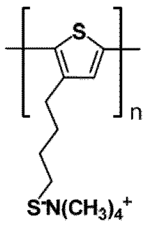

(13)
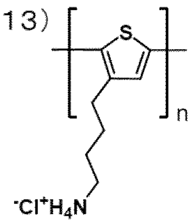
(14)
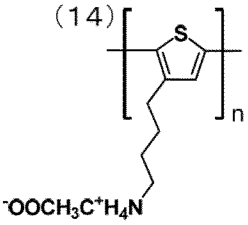
(15)
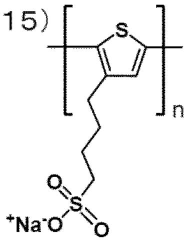
(16)
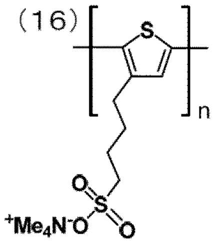

(17)
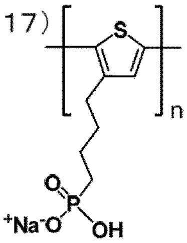
(18)
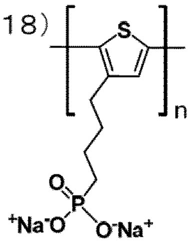
(19)
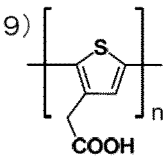
(20)
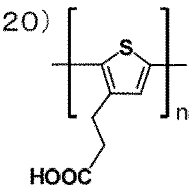

[Chemical formula 2]

(21) 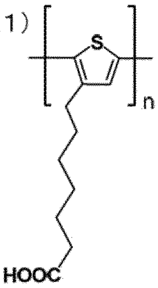

(22) 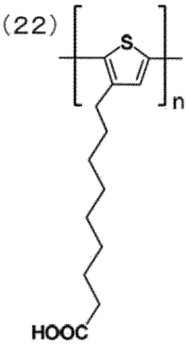

(23) 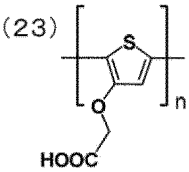

(24) 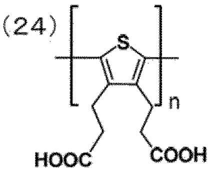

(25) 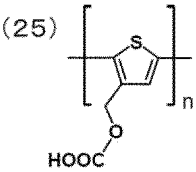

(26) 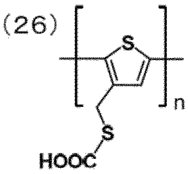

(27) 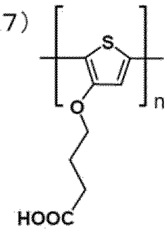

(28) 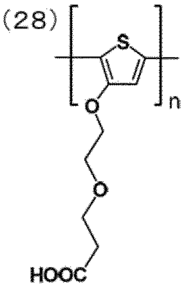

(29) 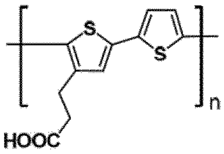

(30) 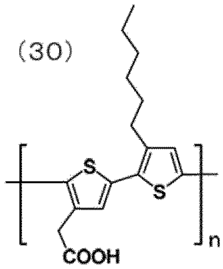

(31) 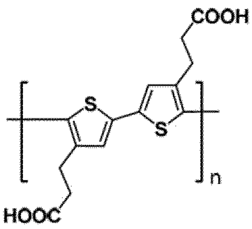

(32) 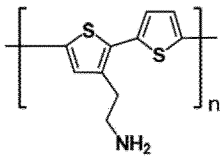

(33) 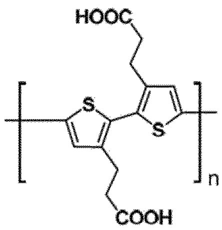

(34) 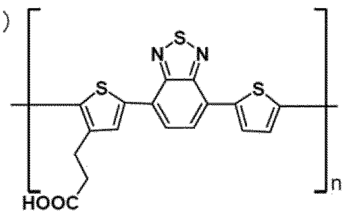

(35) 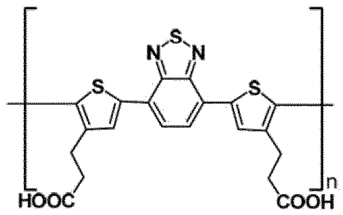

[Chemical formula 3]

(36)
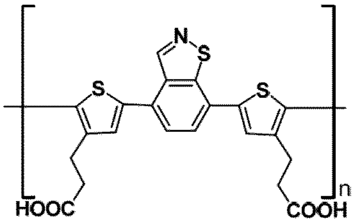

(37)
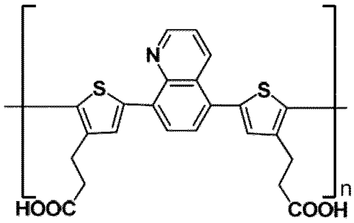

(38)
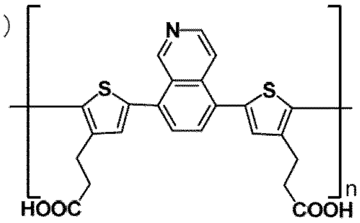

(39)
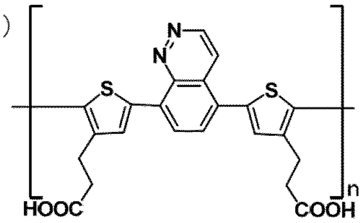

(40)
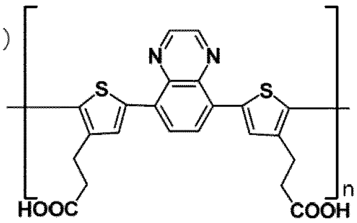

(41)
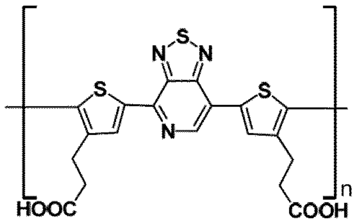

(42)
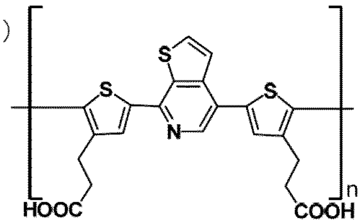

(43)
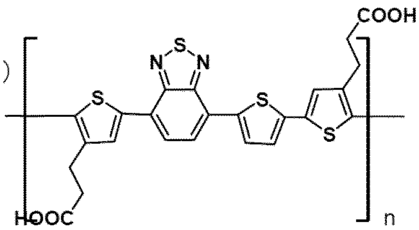

[Chemical formula 4]

(44)

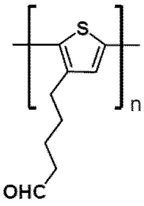

(45)

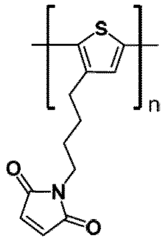

(46)

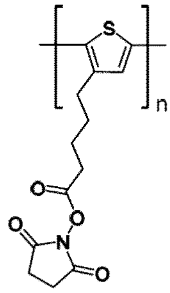

(47)

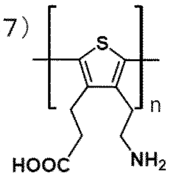

(48)

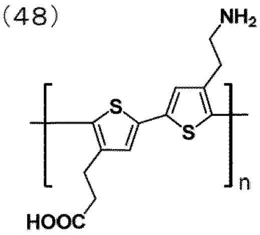

(49)

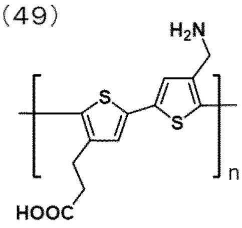

(50)

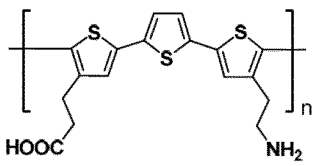

(51)

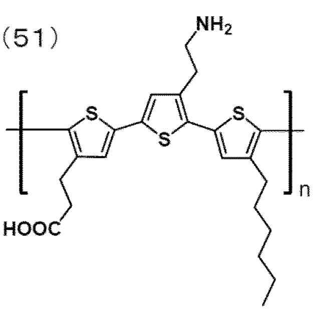

(52)

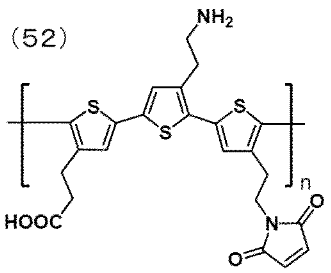

(53)

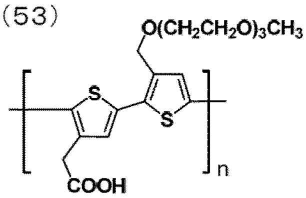

(54)

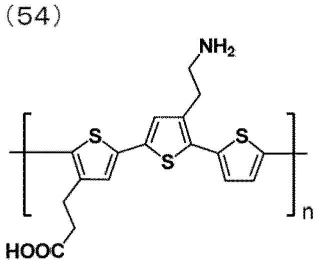

[Chemical formula 5]

(55)

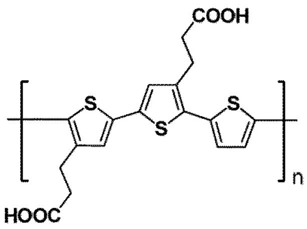

(56)

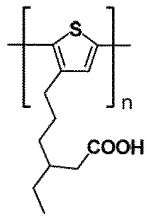

(57)

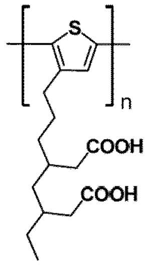

(58)

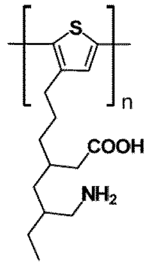

(59)

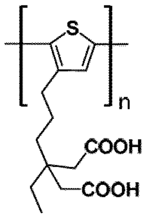

(60)

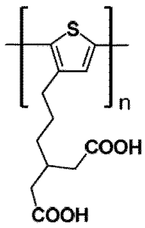

(61)

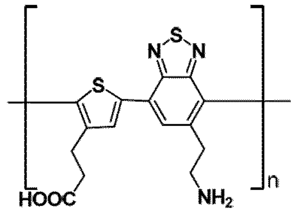

(62)

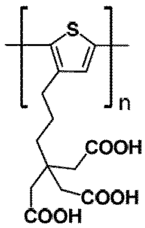

(63)

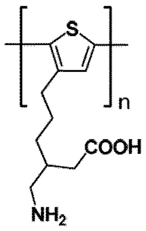

(64)

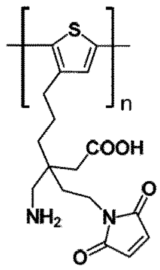

(65)

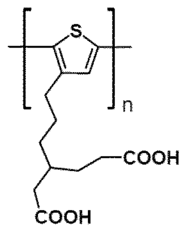

(66)

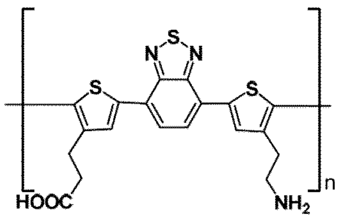

(67)

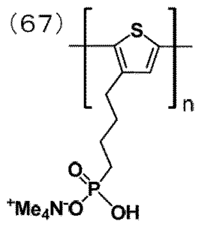

(68)

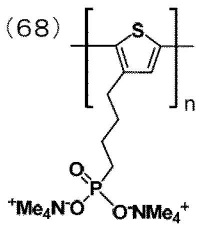

[Chemical formula 6]

(70) 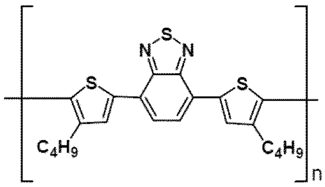

(71) 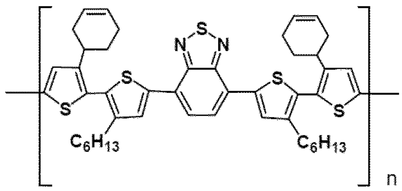

(72) 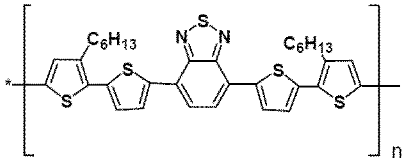

(73) 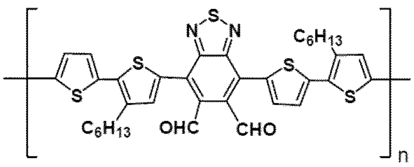

(74) 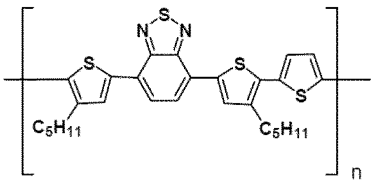

(75) 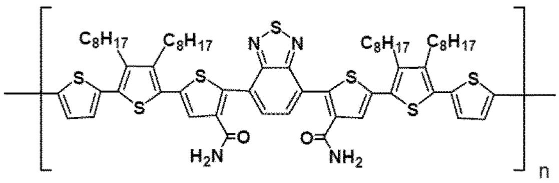

(76) 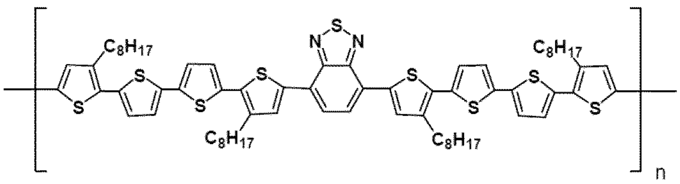

[Chemical formula 7]

(77)

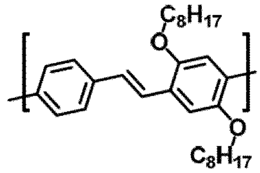

(78)

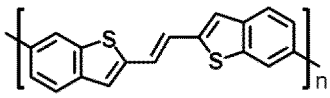

(79)

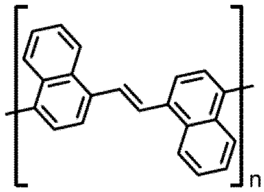

(80)

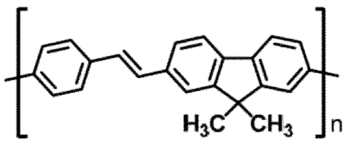

(81)

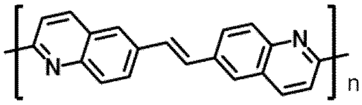

(82)

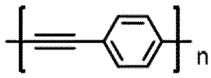

(83)

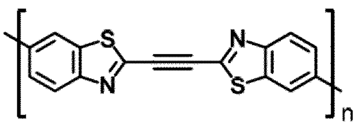

The conjugated polymer can be synthesized by a known method. Examples of the method for synthesizing, as a monomer, a thiophene derivative in which a side chain is introduced into a thiophene include a method in which a halogenated thiophene derivative and thiopheneboronic acid or a thiopheneboronic acid ester are coupled to each other in the presence of a palladium catalyst and a method in which a halogenated thiophene derivative and a thiophene Grignard reagent are coupled to each other in the presence of a nickel or palladium catalyst. Also, in the case of linking a unit other than the above-mentioned thiophene derivative with a thiophene, coupling can be carried out by using a halogenated unit in a similar manner. The conjugated polymer can also be produced by introducing a polymerizable substituent into a terminal of a monomer produced in the above-mentioned manner and allowing the polymerization to proceed in the presence of a palladium catalyst or a nickel catalyst.

Impurities such as raw materials used in the course of synthesis or by-products are preferably removed from

the conjugated polymer. Examples of the method for removing the impurities include a silica gel column graphy method, a Soxhlet extraction method, a filtration method, an ion exchange method, and a chelating method. Two or more of these methods may be employed in combination.

The semiconductor layer may additionally contain an organic semiconductor or an insulating material, as long as the electric characteristics of the CNTs and CNT composites are not impaired.

The film thickness of the semiconductor layer is not particularly limited, and is preferably 1 nm or more and 100 nm or less. Within this range, a three-dimensional conductive path formed by the CNT network can be formed effectively. The thickness is more preferably 1 nm or more and 50 nm or less, further preferably 1 nm or more and 20 nm or less. The film thickness of the semiconductor layer refers to the film thickness on the substrate.

The semiconductor element of the present invention can be particularly suitably applied to a sensor when the film thickness of the semiconductor layer is 1 nm or more and 50 nm or less, further preferably 1 nm or more and 20 nm or less. When the film thickness of the semiconductor layer falls within this range, the change in electric characteristics due to the interaction with the sensing target substance can be sufficiently extracted as an electric signal.

As the method for forming the semiconductor layer, a dry-mode method such as resistive thermal evaporation, electron beam, sputtering, and CVD may be employed. However, from the viewpoint of the cost of production and the applicability to large areas, a coating method is preferably employed. Specifically, a spin coating method, a blade coating method, a slit die coating method, a screen printing method, a bar coater method, a template method, a print transfer method, a dipping-withdrawing method, an inkjet method and the like can be preferably employed. The method for the application may be selected appropriately depending on the desired coating film properties, such as controlled coating thickness and controlled orientation. The coating film formed may be annealed under the atmosphere, under a reduced pressure or under an inert gas atmosphere (e.g., a nitrogen or argon atmosphere).

(Method for Manufacturing Semiconductor Element)

As a method for manufacturing the semiconductor elements shown in Figs. 1 and 6, an example including a step of applying and drying a solution containing CNTs to form a semiconductor layer will be described below. The manufacturing method is not limited to the following.

First, a first electrode 2 and a second electrode 3 are formed on a substrate 1. Examples of the method for formation include known methods, such as metal vapor deposition, a spin coating method, a blade coating method, a slit die coating method, a screen printing method, a bar coater method, a template method, a print transfer method, a dipping-withdrawing method, and an inkjet method. Patterning can be directly performed using a mask or the like, or patterning of a gate electrode can be performed by applying a resist onto a substrate, exposing and developing the resist film in a desired pattern, and then etching the resulting product.

Next, a semiconductor layer 4 is formed by the step of applying and drying a solution containing CNTs to form a semiconductor layer. Specifically, as the method for applying a solution containing CNTs, a spin coating method, a blade coating method, a slit die coating method, a screen printing method, a bar coater method, a template method, a print transfer method, a dipping-withdrawing method, an inkjet method and the like can be preferably employed. The method for the application may be selected appropriately depending on the desired coating film properties, such as controlled coating thickness and controlled orientation. As the method for drying, the coating film formed may be annealed under the atmosphere, under a reduced pressure, or under an inert gas (nitrogen, argon or the like) atmosphere. Specifically, examples of the annealing include annealing under a nitrogen atmosphere at 50 to 150°C for 3 to 30 minutes. The coating film can be dried well by such a drying step. Examples of the solvent used in the coating method include, but are not particularly limited to, water, ethanol, tetrahydrofuran, acetonitrile, N-methylpyrrolidone, γ-butyrolactone, propylene glycol-1-monomethyl ether-2-acetate, chloroform, o-dichlorobenzene, and toluene. The solvents may be used alone or two or more of the solvents may be mixed and used.

The method for manufacturing the semiconductor element shown in Figs. 3 and 7 further includes a step of forming first a gate electrode 5 and an insulating layer 6 on the substrate 1, compared to the method for manufacturing the semiconductor element shown in Figs. 1 and 6.

<Wireless Communication Device>

Next, the wireless communication device of the present invention including the above-mentioned semiconductor element will be described. The wireless communication device can be used as a device in which, like RFID, electrical communication is performed by receiving a carrier wave sent from an antenna mounted on a reader/writer by a RFID tag.

Specifically, for example, the antenna of the RFID tag receives the radio signal transmitted from the antenna mounted on the reader/writer. Then, the alternating current generated according to the signal is converted into a direct current by a rectifier circuit, and the RFID tag generates electromotive force. Subsequently, the electromotive RFID tag receives a command from the radio signal and performs an action corresponding to the command. Subsequently, the

answer of the result corresponding to the command is sent from the antenna on the RFID tag to the antenna on the reader/writer as a radio signal. The action corresponding to the command is performed through at least a known demodulator circuit, an action control logic circuit, and a modulator circuit.

The wireless communication device of the present invention includes at least the above-mentioned semiconductor element and an antenna. Examples of the more specific constitution of the wireless communication device include the constitution shown in Fig. 9. The constitution includes a power source generation unit 51 that rectifies an external modulated wave signal received by an antenna 50 and supply a power source to each unit part, a demodulator circuit 52 that demodulates and sends the modulated wave signal to a controller circuit 53, a modulator circuit 54 that modulates data sent from the controller circuit 53 and sends the data to the antenna, and the controller circuit 53 that writes data modulated by the demodulator circuit 52 into a memory circuit 55, reads data from the memory circuit 55, and sends the data to the modulator circuit 54, wherein the circuits are electrically connected to each other. The demodulator circuit 52, the controller circuit 53, the modulator circuit 54, and the memory circuit 55 are formed of the semiconductor element of the present invention, and may further include a capacitor, a resistive element, a diode and the like. The memory circuit 55 may further include a non-volatile rewritable memory unit such as an EEPROM (Electrically Erasable Programmable Read-Only Memory) and a FeRAM (Ferroelectric Randam Access Memory). The power source generation unit 51 is composed of a capacitor and a diode.

The antenna, the capacitor, the resistive element, the diode, the non-volatile rewritable memory unit may be any conventionally used ones, and the materials and shapes thereof are not particularly limited. A material to be used for electrically connecting these components may be any conventional conductive material. Also, the method for connecting the components may be any method as long as electrical conduction can be performed. The widths and thicknesses of the connecting parts of the components are arbitrarily selected.

(Sensor)

The sensor of the present invention includes the above-mentioned semiconductor element. That is, the sensor includes a semiconductor element including a substrate, a first electrode, a second electrode, and a semiconductor layer disposed between the first electrode and the second electrode, wherein the semiconductor layer contains at least one selected from carbon nanotubes and graphene, and the relationship between the channel length $L_C$ and the channel width $W_C$ of the semiconductor element is $0.01 \leq W_C/L_C \leq 0.8$. More preferably, the semiconductor layer contains CNTs.

When the relationship between the channel length $L_C$ and the channel width $W_C$ of the semiconductor element is $0.01 \leq W_C/L_C \leq 0.8$, the semiconductor element has good switching characteristics, as described above. Therefore, when the semiconductor element is applied to a sensor, a change in electric characteristics due to an interaction with a sensing target substance is large, enabling highly sensitive detection.

When the semiconductor layer contains CNTs, the CNTs form a three-dimensional conductive path by forming a network in the semiconductor layer. When a sensing target substance interacts with the semiconductor layer, the sensing target substance changes the conductivity of the CNTs in the vicinity thereof. Thus, a part of the three-dimensional conduction path interacts and the electric characteristics change.

When the relationship is $0.8 < W_C/L_C$, the channel width is too large relative to the channel length, and thus the sensing target substance is not sufficiently present in the channel width direction. Therefore, a conductive path through the CNTs not affected by the sensing target substance is likely to be generated, and the change in the electric characteristics is small. On the other hand, when the relationship is $W_C/L_C \leq 0.8$, the channel width is narrow relative to the channel length, and thus the sensing target substance is sufficiently present in the channel width direction. Therefore, a conductive path through the CNTs affected by the sensing target substance is likely to be generated, and the change in electric characteristics is large. Such a mechanism would enable highly sensitive detection.

$W_C/L_C$ is more preferably less than 0.5, further preferably less than 0.3. $W_C/L_C$ is 0.01 or more, preferably 0.1 or more. When $W_C/L_C$ falls within this range, a sufficient amount of current flows in the semiconductor element, and a high signal to noise ratio can be obtained.

The range of $W_C/L_C$ is more preferably $0.1 \leq W_C/L_C \leq 0.5$, further preferably $0.1 \leq W_C/L_C \leq 0.3$. When $W_C/L_C$ falls within this range, the sensing target substance tends to be present more sufficiently in the channel width direction, the change in electric characteristics is large, a sufficient amount of current flows in the semiconductor element, and a high signal to noise ratio can be obtained.

The sensor of the present invention preferably includes a plurality of the above-mentioned semiconductor elements. The first electrodes in the plurality of semiconductor elements are electrically connected to each other and the second electrodes therein are electrically connected to each other. Therefore, a high on-state current can be obtained with the off-state current being kept low, better switching characteristics are obtained, and the change in the electric characteristics due to the interaction with the sensing target substance is large, enabling highly sensitive detection.

As described above, when the relationship between the length $L_{CNT}$ of the CNTs and the channel length $L_C$ in the semiconductor element is $5 \leq L_C/L_{CNT}$, the semiconductor element has good switching characteristics. Therefore,

in the sensor of the present invention, the change in electric characteristics due to the interaction with the sensing target substance is large, enabling highly sensitive detection.

When the relationship is $L_C/L_{CNT} < 5$, the CNTs are relatively long relative to the channel length, and the first electrode and the second electrode are highly likely to be electrically connected by the CNTs not affected by the sensing target substance in the channel length direction. Therefore, a conductive path that does not interact with the sensing target is likely to be generated, and the change in the electric characteristics is small.

On the other hand, when the relationship is $5 \leq L_C/L_{CNT}$, the CNTs are sufficiently short relative to the channel length, and the first electrode and the second electrode are less likely to be electrically connected by the CNTs not affected by the sensing target substance in the channel length direction. Therefore, a conductive path that does not interact with the sensing target is unlikely to be generated, and the change in the electric characteristics is large. Such a mechanism would enable highly sensitive detection.

The sensor of the present invention preferably contains a functional group such as a hydroxyl group, a carboxy group, an amino group, a mercapto group, a sulfo group, a phosphonic acid group, an organic or inorganic salt thereof, a formyl group, a maleimide group, and a succinimide group in at least a part of the semiconductor layer. The functional group facilitates fixing of a biological substance that selectively interacts with a sensing target substance to the semiconductor layer.

Among these functional groups, the amino group, the maleimide group, and the succinimide group may or may not have a substituent. Examples of the substituent include an alkyl group, and the substituent may be further substituted.

Examples of the organic salt of the above-mentioned functional groups include, but are not particularly limited to, ammonium salts such as a tetramethylammonium salt, pyridinium salts such as an N-methylpyridinium salt, carboxylate salts such as an imidazolium salt and an acetate, sulfonates, and phosphonates.

Examples of the inorganic salt of the above-mentioned functional groups include, but are not particularly limited to, carbonates, alkali metal salts such as a sodium salt, alkaline earth metal salts such as a magnesium salt, salts made from transition metal ions of copper, zinc, iron and the like, salts made from boron compounds such as tetrafluoroborate, sulfates, phosphates, hydrochlorides, and nitrates.

Examples of the form of introducing a functional group into the semiconductor layer include a form in which the polymer to be attached to the surface of the CNTs has a functional group, and a form in which an organic compound other than the polymer having the functional group is attached to the surface of the CNTs. From the viewpoint of detection sensitivity, a form in which an organic compound other than the polymer is attached to the surface of the CNTs, and at least a part of the organic compound has the functional group is more preferred.

Examples of the organic compound other than the polymer having the functional group include stearylamine, laurylamine, hexylamine, 1,6-diaminohexane, diethylene glycol bis(3-aminopropyl) ether, isophorone diamine, 2-ethylhexylamine, stearic acid, lauric acid, sodium dodecyl sulfate, Tween 20, 1-pyrenecarboxylic acid, 1-aminopyrene, 1-hexabenzocoronenecarboxylic acid, 1-aminohexabenzocoronene, 1-hexabenzocoronene butanecarboxylic acid, 1-pyrenebutanecarboxylic acid, 4-(pyren-1-yl)butan-1-amine, 4-(pyrene-1-yl)butan-1-ol, 4-(pyren-1-yl)butane-1-thiol, 4-(hexabenzocoronen-1-yl)butan-1-amine, 4-(hexabenzocoronen-1-yl)butan-1-ol, 4-(hexabenzocoronen-1-yl)butane-1-thiol, 1-pyrenebutanecarboxylic acid-N-hydroxysuccinimide ester, 1-hexabenzocoronene butane carboxylic acid-N-hydroxysuccinimide ester, biotin, biotin-N-hydroxysuccinimide ester, biotin-N-hydroxy-sulfosuccinimide ester, polyethylene imine, polyethylene glycol, polyvinyl alcohol, polyacrylic acid, sodium polyacrylate, polyacrylic amine, polyacrylamine hydrochloride, polymethacrylic acid, sodium polymethacrylate, polymethacrylamine, polymethacrylamine hydrochloride, alginic acid, sodium alginate, glucose, maltose, sucrose, chitin, amylose, amylopectin, cellulose, carboxymethylcellulose, sucrose, lactose, cholic acid, sodium cholate, deoxycholic acid, sodium deoxycholate, cholesterol, cyclodextrin, xylan, catechin, poly-3-(ethylsulfonic acid-2-yl)thiophene, poly-3-(ethanoic acid-2-yl)thiophene, poly-3-(2-aminoethyl)thiophene, poly-3-(2-hydroxyethyl)thiophene, poly-3-(2-mercaptoethyl)thiophene, polystyrene sulfonic acid, polyvinyl phenol, polyoxypropylene triol, glutaraldehyde, ethylene glycol, ethylenediamine, poly-1H-(propionate-3-yl)pyrrole, 1-adamantanol, 2-adamantanol, 1-adamantanecarboxylic acid, dodecylbenzenesulfonic acid, sodium dodecylbenzenesulfonate, and N-ethylmaleimide. The above-mentioned organic compounds may be used alone or two or more of them may be used in combination.

Examples of the method for attaching an organic compound other than the polymer to CNTs include (I) a method in which CNTs are added to the melted organic compound and the mixture is mixed, (II) a method in which the organic compound is dissolved in a solvent, CNTs are added thereto, and the mixture is mixed, (III) a method in which CNTs are dispersed previously by ultrasonic waves or the like, the organic compound is added thereto, and the mixture is mixed, (IV) a method in which the organic compound and CNTs are added to a solvent, and ultrasonic waves are applied to the mixed system for mixing, (V) a method in which CNTs applied onto a substrate are immersed in the melted organic compound, (VI) a method in which the organic compound is dissolved in a solvent, and the CNTs applied onto a substrate are immersed in the solution. In the present invention, any one of the above-mentioned methods may be employed, or two or more of the methods may be employed in combination.

The sensor of the present invention preferably includes, on at least a part of the semiconductor layer, a biological

substance that selectively interacts with a sensing target substance. The biological substance facilitates selective fixing of a sensing target substance to the semiconductor layer.

The biological substance is not particularly limited, and any substance can be used as long as it can selectively interact with the sensing target substance. Specific examples of the biological substance include enzymes, antigens, antibodies, aptamers, haptens, hapten antibodies, peptides, oligopeptides, polypeptides (proteins), hormones, nucleic acids, oligonucleotides, biotin, biotinylated proteins, avidin, streptavidin, sugars such as saccharide, oligosaccharide, and polysaccharide, low molecular weight compounds, high molecular weight compounds, inorganic substances and complexes thereof, viruses, bacteria, cells, living tissues, and substances that constitute these substances. Among them, substances selected from low molecular weight compounds, antibodies, aptamers, and enzymes are preferred.

Examples of the low molecular weight compounds include a compound having a molecular weight of about 100 to 1000. Specific examples of the low molecular weight compounds include biotin, pyrenebutanoic acid succinimide ester, and pyrenebutanoic acid maleimide ester.

Examples of the antibodies include anti-PSA, anti-hCG, anti-IgE, anti-BNP, anti-NT-proBNP, anti-AFP, anti-CK-MB, anti-PIVKA II, anti-CA15-3, anti-CYFRA, anti-HIV, anti-troponin T, anti-procalcitonin, anti-HbAlc, anti-apolipoprotein, and anti-C-reactive protein (CRP). As the antibodies, IgG antibodies are preferred, and in particular, antibodies having only a variable site (Fab) fragment are preferred.

Examples of the aptamers include oligonucleotide aptamers and peptide aptamers such as an IgE aptamer, a PSA aptamer, and a thrombin aptamer.

Examples of the enzymes include glucose oxidase and peroxidase.

Among them, a substance selected from biotin, an IgE aptamer, and anti-PSA is more preferred.

Examples of the method for fixing a biological substance to the semiconductor layer include, but are not particularly limited to, a method in which the biological substance is directly adsorbed onto the CNT surface, and a method in which the reaction or interaction of the biological substance with the functional group contained in the semiconductor layer is utilized, i.e., a hydroxyl group, a carboxy group, an amino group, a mercapto group, a sulfo group, a phosphonic acid group, an organic or inorganic salt thereof, a formyl group, a maleimide group or a succinimide group. From the viewpoint of the strength of fixation, a method in which the reaction or interaction between the biological substance and the functional group contained in the semiconductor layer is utilized is preferred. For example, when the biological substance contains an amino group, a method in which the reaction or interaction with a carboxy group, an aldehyde group, or a succinimide group contained in the semiconductor layer is utilized is preferred. When the biological substance contains a thiol group, a method in which the reaction or interaction with a maleimide group or the like contained in the semiconductor layer is utilized is preferred.

Among the above, the carboxy group, the succinimide ester group, and the amino group are suitable for utilizing the reaction or interaction with the biological substance and facilitate the fixation of the biological substance to the semiconductor layer. Therefore, the functional group contained in the semiconductor layer is preferably a carboxy group, a succinimide ester group, or an amino group.

Specific examples of the reaction or interaction include, but are not particularly limited to, chemical bonds, hydrogen bonds, ionic bonds, coordinate bonds, electrostatic force, and van der Waals force, and the reaction or interaction can be selected appropriately depending on the types of the functional group and the chemical structure of the biological substance. If necessary, a part of the functional group and/or biological substance may be converted into another appropriate functional group and then fixed. A linker such as terephthalic acid may be utilized between the functional group and the biological substance.

Examples of the process of fixation include, but are not particularly limited to, a process in which a solution containing a biological substance is added to a solution or a semiconductor layer containing CNTs to fix the biological substance with heating, cooling, and shaking the mixture as necessary, and then excess components are removed by washing or drying the mixture. Examples of the combination of the functional group/biological substance contained in the semiconductor layer in the sensor of the present invention include a carboxy group/glucose oxidase, a carboxy group/T-PSA-mAb (a monoclonal antibody for prostate specific antigen), a carboxy group/hCG-mAb (a human chorionic gonadotropin antibody), a carboxy group/an artificial oligonucleotide (an IgE (immunoglobulin E) aptamer), a carboxy group/anti-IgE, a carboxy group/IgE, a carboxy group/amino group terminal RNA (an HIV-1 (human immunodeficiency virus) receptor), a carboxy group/a natriuretic peptide receptor, an amino group/RNA (an HIV-1 antibody receptor), an amino group/biotin, a mercapto group/T-PSA-mAb, a mercapto group/hCG-mAb, a sulfo group/T-PSA-mAb, a sulfo group/hCG-mAb, a phosphonic acid group/T-PSA-mAb, a phosphonic acid group/hCG-mAb, an aldehyde group/an oligonucleotide, an aldehyde group/an anti-AFP polyclonal antibody (an antibody for human tissue immunostaining), a maleimide group/cysteine, succinimide ester/streptavidin, sodium carboxylate/glucose oxidase, a carboxy group/anti-troponin T (a troponin T antibody), a carboxy group/anti-CK-MB (a creatinine kinase MB antibody), a carboxy group/anti-PIVKA-II (a protein induced by vitamin K absence or an antagonist-II antibody), a carboxy group/anti-CA15-3, a carboxy group/anti-CEA (a carcinoembryonic antigen antibody)), a carboxy group/anti-CYFRA (a cytokeratin 19 fragment antibody), and a carboxy group/anti-p53 (a p53 protein antibody). When the biological substance contains a functional group,

the biological substance can be preferably used as an organic compound containing a functional group. Specific examples of the biological substance containing a functional group include an IgE aptamer, biotin, streptavidin, a natriuretic peptide receptor, avidin, T-PSA-mAb, hCG-mAb, IgE, amino group terminal RNA, RNA, an anti-AFP polyclonal antibody, cysteine, anti-troponin T, anti-CK-MB, anti-PIVKA-II, anti-CA15-3, anti-CEA, anti-CYFRA, and anti-p53.

The biological substance that selectively interacts with a sensing target substance may be fixed to the semiconductor layer separately from or at the same time as the formation of the semiconductor layer. Examples of the method for separately fixing the biological substance include a method in which a semiconductor layer is formed on an organic film by applying a CNT solution and then the semiconductor layer is immersed in a solution containing a biological substance that selectively interacts with a sensing target substance. Examples of the method for fixing the biological substance at the same time include a method in which a semiconductor layer is formed using CNT composites originally containing a biological substance that selectively interacts with a sensing target substance. If necessary, excess components may be removed by washing or drying.

In the sensor including the semiconductor element formed as shown in Fig. 1, when a sensing target substance or a solution, a gas, or a solid containing the sensing target substance is placed in the vicinity of the semiconductor layer 4, the value of the current flowing between the first electrode 2 and the second electrode 3 or the electric resistance value changes. By measuring the change, the sensing target substance can be detected.

Also, in the sensor including the semiconductor element formed as shown in Fig. 3, 4, or 6, when a sensing target substance or a solution, a gas, or a solid containing the sensing target substance is placed in the vicinity of the semiconductor layer 4, the value of the current flowing between the first electrode 2 and the second electrode 3, that is, the current flowing through the semiconductor layer 4 changes. By measuring the change, the sensing target substance can be detected.

In the sensor including the semiconductor element in Fig. 3, 4, or 7A, the value of the current flowing through the semiconductor layer 4 can be controlled by the voltage of the gate electrode 5. Therefore, when the value of the current flowing between the first electrode and the second electrode is measured with changing the voltage of the gate electrode 5, a two-dimensional graph (I-V graph) is obtained.

The sensing target substance may be detected using some or all of the characteristic values, or the sensing target substance may be detected using the ratio of the maximum current to the minimum current, that is, the on/off ratio. Further, the sensing target substance may be detected using known electric characteristics obtained from the semiconductor element, such as the resistance value, impedance, transconductance, and capacitance.

The sensing target substance may be used alone or may be mixed with other substances or solvents. When a sensing target substance or a solution, a gas or a solid containing the sensing target substance is placed in the vicinity of the semiconductor layer 4, the semiconductor layer 4 interacts with the sensing target substance as described above. Thus, the electric characteristics of the semiconductor layer 4 change, and the change is detected as a change in any of the above-mentioned electric signals.

Specific examples of the sensing target substance include, but are not particularly limited to, enzymes, antigens, antibodies, haptens, peptides, oligopeptides, polypeptides (proteins), hormones, nucleic acids, oligonucleotides, sugars such as saccharide, oligosaccharide, and polysaccharide, low molecular weight compounds, inorganic substances, and complexes thereof, viruses, bacteria, cells, living tissues, and substances that constitute these substances. These substances react or interact with either of a functional group such as a hydroxyl group, a carboxy group, an amino group, a mercapto group, a sulfo group, a phosphonic acid group, an organic or inorganic salt thereof, a formyl group, a maleimide group, and a succinimide group or a biological substance, and change electric characteristics of the semiconductor layer in the sensor of the present invention.

Examples of the low molecular weight compounds include, but are not particularly limited to, compounds that are gaseous at normal temperature and pressure such as ammonia or methane emitted from a living body, and solid compounds such as uric acid. The solid compounds such as uric acid are preferred.

The sensing target substance is preferably selected from sugars, proteins, viruses, and bacteria. Examples of the sugars include glucose. Examples of the proteins include PSA, hCG, IgE, BNP, NT-proBNP, AFP, CK-MB, PIVKAII, CA15-3, CYFRA, anti-p53, troponin T, procalcitonin, HbA1c, apolipoprotein, and C reactive protein (CRP). Examples of the viruses include HIV, influenza virus, hepatitis B virus, and hepatitis C virus. Examples of the bacteria include Chlamydia, Staphylococcus aureus, and Enterohemorrhagic Escherichia coli.

Examples of the combination of a biological substance/a sensing target substance include glucose oxidase/$\beta$-D-glucose, T-PSA-mAb (a monoclonal antibody for prostate specific antigen)/PSA (a prostate specific antigen), hCG-mAb (a human chorionic gonadotropin antibody)/hCG (human chorionic gonadotropin), an artificial oligonucleotide/IgE (immunoglobulin E), diisopropylcarbodiimide/IgE, anti-IgE/IgE, amino group terminal RNA/HIV-1 (a human immunodeficiency virus), a natriuretic peptide receptor/BNP (brain natriuretic peptide), RNA/HIV-1, biotin/avidin, an oligonucleotide/nucleic acid, an anti-AFP polyclonal antibody (an antibody for human tissue immunostaining)/$\alpha$ fetoprotein, streptavidin/biotin, avidin/biotin, anti-troponin T (a troponin T antibody)/troponin T, anti-CK-MB (a creatinine kinase MB antibody)/CK-MB (creatinine kinase MB), anti-PIVKA-II (a protein induced by vitamin K absence or an antagonist-II antibody)/PIVKA-II (a protein induced by vitamin K absence or antagonist-II), anti-CA15-3/CA15-3, anti-CEA (a carcinoembryonic antigen antibody)/CEA (a carcinoembryonic antigen), anti-CYFRA (a cytokeratin 19 fragment antibody)/CYFRA (a cytokeratin 19 fragment), and anti-p53 (a p53 protein antibody)/p53 (p53 protein).

Examples of a sample containing the sensing target substance include, but are not particularly limited to, expired air, sweat, urine, saliva, stool, blood, serum, plasma, and buffer. Samples selected from sweat, urine, saliva, blood, serum, plasma, and buffer are preferred.

EXAMPLES

Hereinbelow, the present invention will be described more specifically with reference to examples. However, the invention is not limited to the examples. The CNTs used are as follows.

CNT: manufactured by Changchun New Industries Optoelectronics Tech. Co., Ltd., single-walled CNTs, 95% by weight of semiconducting CNTs, 5% by weight of metallic CNTs

Among the compounds used, those written in abbreviation are shown below.

P3HT: poly-3-hexylthiophene
PBS: phosphate buffered saline
BSA: bovine serum albumin
IgE: immunoglobulin E
PSA: prostate specific antigen
o-DCB: o-dichlorobenzene
DMF: dimethylformamide
DMSO: dimethylsulfoxide
EDC: 1-ethyl-3-(3-dimethylaminopropyl)carbodiimide hydrochloride
THF: tetrahydrofuran

The length of the CNTs in each example and comparative example was measured by a method of randomly picking up 20 CNTs from an image obtained by an atomic force microscope and obtaining an average value of their lengths.

The molecular weight of the polymer was measured as follows. A sample was filtered with a membrane filter having a pore diameter of 0.45 μm, and then subjected to GPC (Gel Permeation Chromatography, HLC-8220GPC manufactured by Tosoh Corporation) (developing solvent: chloroform, developing speed: 0.4 mL/min). The molecular weight was determined by conversion using a polystyrene standard sample.

The signal to noise ratio for the evaluation as a sensor was calculated as follows. Linear approximation of the current value change from 20 seconds to 80 seconds from the start of measurement was performed, the absolute value of the difference between the measurement data and the linear approximation data was calculated for each time point, and the average value of the absolute values was taken as noise. The signal was defined as the absolute value of the amount of change in the current value before and after the addition of proteins. The signal to noise ratio was calculated by dividing the signal value by the noise value.

The arithmetic mean roughness (Ra) of the substrate surface between the first electrode and the second electrode was calculated as follows. The cross section of the substrate between the first electrode and the second electrode was observed with a TEM, and the arithmetic mean roughness (Ra) of 10 randomly selected points in the obtained image was calculated and taken as the arithmetic mean roughness of the substrate surface. The reference length was 1 μm.

The degree of integration was obtained by calculating how many squares whose side lengths are the channel length or the channel width, whichever is larger, are included per unit area (1 $mm^2$). That is, the degree of integration was obtained by calculating the area of the square using the larger one of the channel length and the channel width as the side length of the square, and dividing 1 $mm^2$ by the area.

Example 1

(1) Production of semiconductor solution

CNTs (1.5 mg) and P3HT (1.5 mg) were added to 15 mL of chloroform, and the mixture was stirred ultrasonically using an ultrasonic homogenizer (VCX-500, manufactured by TOKYO RIKAKIKAI CO, LTD.) at an output of 250 W for 30 minutes with being ice-cooled to produce a CNT dispersion A (the concentration of CNT composites in the solvent: 0.1 g/l).

Subsequently, a semiconductor solution for forming a semiconductor layer was produced. The CNT dispersion A was filtered using a membrane filter (pore diameter: 10 μm, diameter: 25 mm, Omnipore membrane manufactured by Millipore Corporation), and then further filtered using a membrane filter (pore diameter: 5 μm, diameter: 25 mm, Omnipore membrane manufactured by Millipore Corporation). o-DCB (45 mL) was added to 5 mL of the obtained filtrate

to produce a semiconductor solution A (the concentration of CNT composites in the solvent: 0.01 g/l).

(2) Production of insulating layer solution

Methyltrimethoxysilane (61.41 g) (0.45 mol), β-(3,4-epoxycyclohexyl)ethyltrimethoxysilane (12.35 g) (0.05 mol), phenyltrimethoxysilane (99.33 g) (0.5 mol), and polyethylene glycol triethoxysilane (50.08 g) (0.5 mol) were dissolved in propylene glycol monobutyl ether (boiling point: 170°C) (203.01 g), and water (54.90 g) and phosphoric acid (0.864 g) were added to the resulting solution with stirring. The resulting solution was heated at a bath temperature of 105°C for 2 hours to increase the inside temperature to 90°C, thereby a component mainly composed of methanol that was produced as a by-product was distilled away. Subsequently, the solution was heated at a bath temperature of 130°C for 2 hours to increase the inside temperature to 118°C, thereby a component mainly composed of water and propylene glycol monobutyl ether was distilled away. Then, the solution was cooled to room temperature to produce a polymer solution A having a solid material concentration of 28.5% by weight. The obtained polymer solution A (10 g), aluminum bis(ethylacetoacetate)mono(2,4-pentanedionate) (trade name "Aluminum Chelate D", manufactured by Kawaken Fine Chemicals Co., Ltd.) (13.0 g), and propylene glycol monoethyl ether acetate (hereinafter referred to as PGMEA) (42.0 g) were mixed and stirred at room temperature for 2 hours to produce a polymer solution B.

(3) Production of semiconductor element

The semiconductor element shown in Fig. 4 was produced. The polymer solution B produced by the method described in (2) above was spin-coated (800 rpm × 20 seconds) onto a glass substrate (film thickness: 0.7 mm), and the resulting product was heat-treated at 120°C for 5 minutes. Then, the polymer solution B was spin-coated (800 rpm × 20 seconds) again and the resulting product was heat-treated at 200°C for 30 minutes under a nitrogen stream to form an insulating layer having a thickness of 400 nm and made from polysiloxane. Gold was deposited under vacuum at a thickness of 50 nm on the insulating layer, then a photoresist (trade name: "LC100-10Cp", manufactured by Rohm and Haas Company) was spin-coated (1000 rpm × 20 seconds), and then the resulting product was dried by heating at 100°C for 10 minutes.

The photoresist film thus formed was exposed to light through a mask using a parallel light mask aligner (PLA-501F, manufactured by Cannon Inc.) to form a pattern, was then subjected to shower development for 70 seconds with ELM-D (trade name, manufactured by Mitsubishi Gas Chemical Company, Inc.) (a 2.38% by weight aqueous tetramethylammonium hydroxide solution) using an automatic developer (AD-2000, manufactured by Takizawa Co., Ltd.), and was then washed with water for 30 seconds. Subsequently, the resulting product was etched with AURUM-302 (trade name, manufactured by Kanto Chemical Co., Inc.) for 5 minutes, and was then washed with water for 30 seconds. The resulting product was immersed in AZ Remover 100 (trade name, manufactured by AZ Electronic Materials) for 5 minutes to remove the resist, was then washed with water for 30 seconds, and was then dried by heating at 120°C for 20 minutes. In this manner, a first electrode 2, a second electrode 3, and a gate electrode 5 were formed. Subsequently, a silver-silver chloride ink (manufactured by BAS Inc.) was applied onto the gate electrode 5 and the resulting product was heat-treated at 100°C for 10 minutes under a nitrogen stream.

The width of the first electrode 2 and the second electrode 3 (channel width) was 200 μm, and the distance between the first electrode 2 and the second electrode 3 (channel length) was 250 μm. The gate electrode 5 was disposed parallel to the second electrode 3, and the distance between the gate electrode 5 and the second electrode 3 was 5 mm. The semiconductor solution A (400 pl) produced by the method mentioned in (1) above was dropped on the substrate having electrodes formed thereon using an inkjet device (manufactured by Cluster Technology Co., Ltd.) to form a semiconductor layer 4, and then the semiconductor layer 4 was heat-treated on a hot plate under a nitrogen stream at 150°C for 30 minutes to produce a semiconductor element.

Next, the characteristics of current (Id) between the first electrode and the second electrode and voltage (Vsd) between the first electrode and the second electrode were measured with changing the voltage (Vg) of the gate electrode 5 of the semiconductor element. The measurement was carried out under 100 μL of 0.01 M PBS (pH 7.2, manufactured by Wako Pure Chemical Industries, Ltd.) (temperature: 20°C, humidity: 35%) using a semiconductor property evaluation system model 4200-SCS (manufactured by Keithley Instruments). The on/off ratio was 1E + 4 when Vsd was fixed at -0.2 V and Vg was changed between 0 to -1 V.

Next, the semiconductor layer 4 was immersed in 6.0 mg of pyrene butanoic acid succinimide ester (manufactured by AnaSpec, Inc.) in 1.0 mL of DMF (manufactured by Wako Pure Chemical Industries, Ltd.) for 1 hour. Then, the semiconductor layer 4 was sufficiently rinsed with DMF and DMSO (manufactured by Wako Pure Chemical Industries, Ltd.). Next, the semiconductor layer 4 was immersed overnight in 10 μL of diethylene glycol bis(3-aminopropyl) ether (manufactured by Tokyo Chemical Industry Co., Ltd.) in 1.0 mL of DMSO. Thereafter, the semiconductor layer 4 was sufficiently rinsed with DMSO and pure water. Next, the semiconductor layer 4 was immersed in 1.0 mg of biotin N-hydroxysulfosuccinimide ester in 1.0 mL of 0.01 M PBS overnight. Thereafter, the semiconductor layer 4 was sufficiently

rinsed with pure water to produce a semiconductor element in which biotin was fixed to the semiconductor layer 4.

The above-mentioned semiconductor element was immersed in 5.0 mg of BSA in 5.0 mL of 0.01 M PBS overnight. Thereafter, the semiconductor layer 4 was sufficiently rinsed with pure water to produce a semiconductor element in which the semiconductor layer 4 was modified with biotin and BSA as a protective agent.

(4) Evaluation as sensor

The semiconductor layer 4 of the semiconductor element modified with biotin produced in (3) was immersed in 100 μL of 0.01 M PBS, and the value of current flowing between the first electrode 2 and the second electrode 3 was measured. The measurement was carried out using a semiconductor property evaluation system model 4200-SCS (manufactured by Keithley Instruments). The measurement was carried out at a voltage between the first electrode and the second electrode (Vsd) of -0.2 V, and a voltage between the first electrode and the gate electrode (Vg) of -0.6 V. After 2 minutes of the start of measurement, 20 μL of 5 μg/mL BSA-0.01 M PBS solution, after 7 minutes, 20 μL of 5 μg/mL IgE (manufactured by YAMASA CORPORATION.)-0.01 M PBS solution, and after 12 minutes, 20 μL of 5 μg/mL avidin (manufactured by Wako Pure Chemical Industries, Ltd.)-0.01 M PBS solution were added to 0.01 M PBS in which the semiconductor layer 4 was immersed. The results are shown in Fig. 5. Only when avidin was added, the current value decreased by 7.0% from the current value before addition. The signal to noise ratio was 24.

Example 2

(1) Production of semiconductor element

A semiconductor element was produced in the same manner as in Example 1 except that the channel length was 300 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 7.1% from the current value before addition. The signal to noise ratio was 25.

Example 3

(1) Production of semiconductor element

A semiconductor element was produced in the same manner as in Example 1 except that the channel length was 400 μm and 600 pL of the semiconductor solution A was dropped, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 8.0% from the current value before addition. The signal to noise ratio was 30.

Example 4

(1) Production of semiconductor element

A semiconductor element was produced in the same manner as in Example 1 except that the channel length was 1000 μm and 1200 pL of the semiconductor solution A was dropped, and the semiconductor element in which the

semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 9.0% from the current value before addition. The signal to noise ratio was 33.

Example 5

(1) Production of semiconductor element

A semiconductor element was produced in the same manner as in Example 1 except that the channel length was 2000 μm and 2000 pL of the semiconductor solution A was dropped, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 8.8% from the current value before addition. The signal to noise ratio was 31.

Example 6

(1) Production of semiconductor element

A semiconductor element was produced in the same manner as in Example 5 except that the channel width was 100 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 7.7% from the current value before addition. The signal to noise ratio was 15.

Example 7

(1) Production of semiconductor element

A semiconductor element was produced in the same manner as in Example 5 except that the channel width was 20 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution,

after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 7.1% from the current value before addition. The signal to noise ratio was 12.

Example 8

(1) Production of semiconductor element

A semiconductor element was produced in the same manner as in Example 1 except that the channel width was 20 μm and the channel length was 100 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 8.7% from the current value before addition. The signal to noise ratio was 32.

Example 9

(1) Production of semiconductor element

A semiconductor element was produced in the same manner as in Example 8 except that the filtration with a membrane filter (pore diameter: 10 μm) was not carried out, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 8.6% from the current value before addition. The signal to noise ratio was 33.

Example 10

(1) Production of semiconductor element

A semiconductor element was produced in the same manner as in Example 9 except that the channel width was 15 μm and the channel length was 20 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 6.5% from the current value before addition. The signal to noise ratio was 21.

Example 11

(1) Production of semiconductor element

A semiconductor element was produced in the same manner as in Example 9 except that the channel width was 7 μm and the channel length was 10 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 6.2% from the current value before addition. The signal to noise ratio was 20.

Example 12

(1) Production of semiconductor element

A semiconductor element was produced in the same manner as in Example 9 except that the channel width was 4 μm and the channel length was 6 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 5.0% from the current value before addition. The signal to noise ratio was 18.

Example 13

(1) Production of semiconductor solution

A compound (70) was synthesized by the method shown in reaction scheme 1.

(Reaction Scheme 1)

[Chemical formula 8]

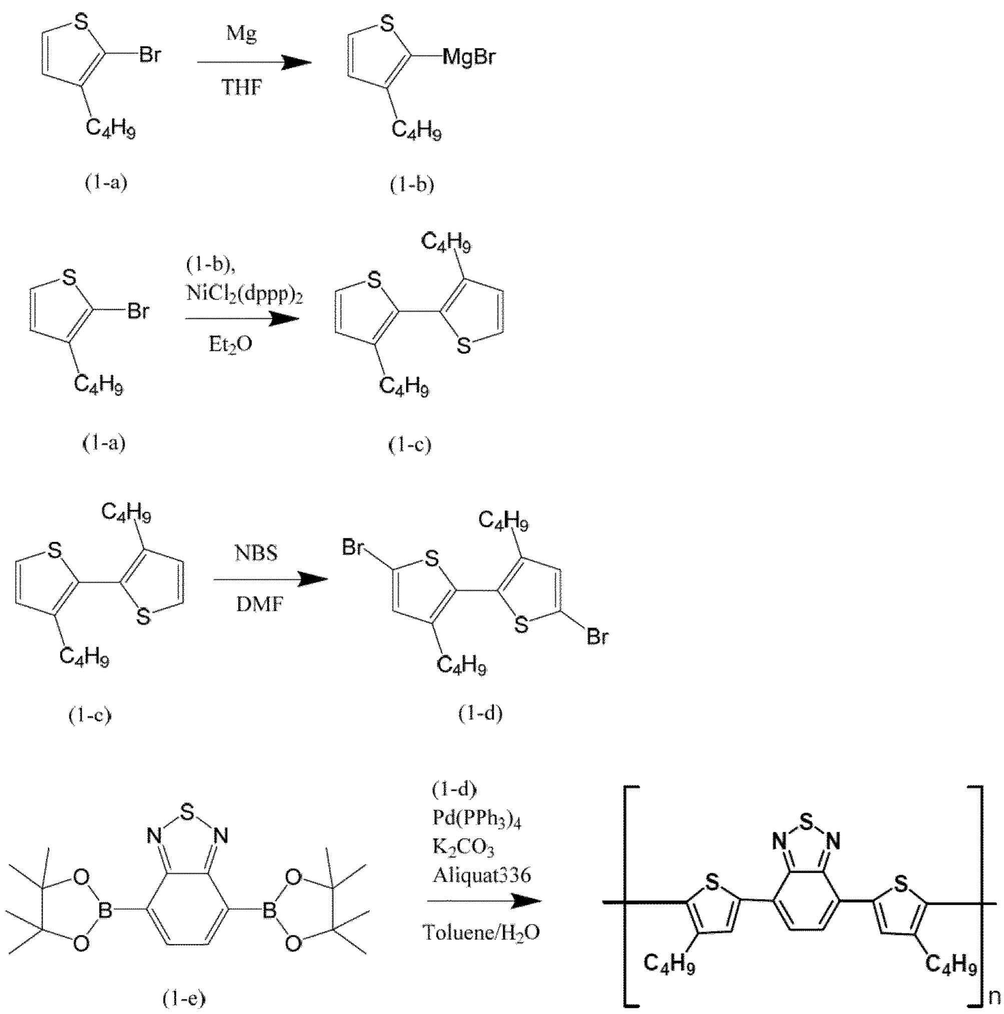


(70)

While stirring a solution of 0.73 g of magnesium in 20 mL of THF, a solution of 4.3 g of a compound (1-a) (manufactured by Tokyo Chemical Industry Co., Ltd.) in THF (20 mL) was added dropwise to the solution over 1 hour, and the mixture was further stirred at 80°C for 24 hours to produce a solution of a compound (1-b).

Separately, while stirring a solution of 4.8 g of the compound (1-a) and 0.22 g of $NiCl_2(dppp)_2$ (manufactured by Sigma-Aldrich Co. LLC.) in 100 mL of diethyl ether (manufactured by Wako Pure Chemical Industries, Ltd.) at 0°C, the solution of the compound (1-b) was added dropwise to the solution. After stirring at 50°C for 24 hours, 2 M hydrochloric acid was added to the obtained solution, and the organic layer was collected therefrom. The organic layer was washed with water (200 mL) and then dried over magnesium sulfate. From the resulting solution, the solvent was distilled away using an evaporator and then the product was purified by distillation to produce 2.10 g of a compound (1-c).

The compound (1-c) was dissolved in 8 mL of DMF, a solution of 2.82 g of N-bromosuccinimide in DMF (16 mL) was added thereto, and the mixture was stirred under a nitrogen atmosphere at 5 to 10°C for 24 hours. To the resulting solution, water (100 ml) and hexane (100 ml) were added, and the organic layer was collected therefrom. The organic layer was washed with water (200 mL) and then dried over magnesium sulfate. The solvent was distilled away from the resulting solution using an evaporator and then the solution was purified using column chromatography (filler: silica gel, eluting solution: hexane) to produce 2.96 g of a compound (1-d).

The compound (1-d) (0.28 g) and a compound (1-e) (manufactured by Tokyo Chemical Industry Co., Ltd.) (0.25 g) were dissolved in 30 mL of toluene. Water (10 ml), potassium carbonate (1.99 g), tetrakis(triphenylphosphine)palladium(0) (manufactured by Tokyo Chemical Industry Co., Ltd.) (80 mg), and Aliquat(R)336 (manufactured by Sigma-Aldrich Co. LLC.) (1 drop) were added to the resulting solution, and the solution was stirred at 100°C for 24 hours under

a nitrogen atmosphere. Methanol (100 mL) was added to the resulting solution, and the produced solid was collected by filtration and washed with methanol, acetone, and hexane in this order. The resulting solid was dissolved in chloroform (200 mL). The solution was allowed to pass through a silica gel short column (eluting solution: chloroform), then concentrated to dryness, and then washed with methanol to produce the compound (70) (310 mg). The compound (70) had a weight average molecular weight of 10395, a number average molecular weight of 8682, and a degree of polymerization n of 21.0.

Thereafter, a semiconductor element was produced in the same manner as in Example 3 except that the compound (70) was used instead of P3HT, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 8.3% from the current value before addition. The signal to noise ratio was 33.

Example 14

(1) Production of semiconductor element

The semiconductor element in which the semiconductor layer 4 was modified with an IgE aptamer and BSA as a protective agent was obtained in the same manner as in Example 3 except that the semiconductor layer 4 was immersed overnight in a solution of 1 mg/mL 5' terminal aminated IgE aptamer (manufactured by Fasmac) in 1.0 mL of 0.01 M PBS instead of the biotin N-hydroxysulfosuccinimide ester solution.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL avidin-0.01 M PBS solution, and after 12 minutes, 20 μL of 5 μg/mL IgE-0.01 M PBS solution were added to 0.01 M PBS in which the semiconductor layer 4 was immersed. Only when IgE was added, the current value decreased by 7.9% from the current value before addition. The signal to noise ratio was 30.

Example 15

(1) Production of semiconductor element

A semiconductor element was produced in the same manner as in Example 14 except that the semiconductor layer 4 was immersed in 100 μg/mL anti-PSA in 1.0 mL of 0.01 M PBS instead of the IgE aptamer solution, and the semiconductor element in which the semiconductor layer 4 was modified with anti-PSA, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL avidin-0.01 M PBS solution, and after 12 minutes, 20 μL of 5 μg/mL PSA-0.01 M PBS solution were added to 0.01 M PBS in which the semiconductor layer 4 was immersed. Only when PSA was added, the current value decreased by 7.8% from the current value before addition. The signal to noise ratio was 30.

Example 16

(1) Production of semiconductor element

A semiconductor element shown in Fig. 8 was produced. The semiconductor element in which the semiconductor

layers 14 and 24 were modified with biotin, which is a biological substance that selectively interacts with a sensing target substance, and BSA as a protective agent was obtained in the same manner as in Example 3 except that two pairs of electrodes, that is, the first electrode 12 and the first electrode 22, and the second electrode 13 and the second electrode 23 were formed using a different mask pattern from that in Example 3, and two pairs of semiconductor layers, that is, the semiconductor layers 14 and 24 were formed using an inkjet device. The distance between the semiconductor element 10 and the semiconductor element 20 was 1 mm.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 9.1% from the current value before addition. The signal to noise ratio was 38.

Comparative Example 1

(1) Production of semiconductor element

A semiconductor element was produced in the same manner as in Example 1 except that the channel length was 200 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 1.5% from the current value before addition. The signal to noise ratio was 9.

Comparative Example 2

(1) Production of semiconductor element

A semiconductor element was produced in the same manner as in Example 1 except that the channel length was 100 μm, and the semiconductor element in which the semiconductor layer 4 was modified with biotin, which is a biological substance that selectively interacts with a sensing target substance, and BSA as a protective agent was obtained.

(2) Evaluation as sensor

To evaluate the semiconductor element produced above as a sensor, measurement was carried out in the same manner as in Example 1. After 2 minutes of the start of measurement, 20 μL of 5 μg/mL BSA-0.01 M PBS solution, after 7 minutes, 20 μL of 5 μg/mL IgE-0.01 M PBS solution, and after 12 minutes, 20 μL of 5 μg/mL avidin-0.01 M PBS solution were added to 0.01 M PBS in which the semiconductor layer 4 was immersed. Only when avidin was added, the current value decreased by 1.1% from the current value before addition. The signal to noise ratio was 7.

Example 17

(1) Production of semiconductor element

A semiconductor element shown in Fig. 3 was produced. A gate electrode 5 was formed on a glass substrate (film thickness: 0.7 mm) by depositing aluminum under vacuum to a film thickness of 50 nm with a metal mask interposed therebetween. Subsequently, the polymer solution B produced by the method described in (2) of Example 1 above was spin-coated (800 rpm × 20 seconds) onto the glass substrate (film thickness: 0.7 mm), and the resulting product was heat-treated at 120°C for 5 minutes. Then, the polymer solution B was spin-coated (800 rpm × 20 seconds) again and

the resulting product was heat-treated at 200°C for 30 minutes under a nitrogen stream to form an insulating layer 6 having a thickness of 400 nm and made from polysiloxane. Gold was deposited under vacuum at a thickness of 50 nm onto the insulating layer, then a photoresist was spin-coated (1000 rpm × 20 seconds), and then the resulting product was dried by heating at 100°C for 10.

The photoresist film thus formed was exposed to light through a mask using a parallel light mask aligner to form a pattern, was then subjected to shower development for 70 seconds with ELM-D (a 2.38% by weight aqueous tetramethylammonium hydroxide solution) using an automatic developer, and was then washed with water for 30 seconds. Subsequently, the resulting product was etched with AURUM-302 for 5 minutes, and was then washed with water for 30 seconds. The resulting product was immersed in AZ Remover 100 for 5 minutes to remove the resist, was then washed with water for 30 seconds, and was then dried by heating at 120°C for 20 minutes. In this manner, a first electrode 2 and a second electrode 3 were formed.

The width of the first electrode 2 and the second electrode 3 (channel width) was 20 μm, and the distance between the first electrode 2 and the second electrode 3 (channel length) was 25 μm. The semiconductor solution A (400 pl) produced by the method mentioned in (1) of Example 1 above was dropped on the substrate having electrodes formed thereon using an inkjet device (manufactured by Cluster Technology Co., Ltd.) to form a semiconductor layer 4, and then the semiconductor layer 4 was heat-treated on a hot plate under a nitrogen stream at 150°C for 30 minutes to produce a semiconductor element.

(2) Evaluation as FET

The characteristics of current (Id) between the first electrode 2 and the second electrode 3 and voltage (Vsd) between the first electrode 2 and the second electrode 3 were measured with changing the voltage (Vg) of the gate electrode 5 of the semiconductor element. Measurement was carried out at a temperature of 20°C and a humidity of 35% using a semiconductor property evaluation system model 4200-SCS. When Vsd was fixed at -5 V and Vg was changed from +20 V to 20 V, the on-state current was 33 μA and the off-state current was 13 pA.

Example 18

(1) Production of semiconductor element

A semiconductor element was produced in the same manner as in Example 17 except that the channel length was 30 μm.

(2) Evaluation as FET

To evaluate the semiconductor element produced above as a FET, measurement was carried out in the same manner as in Example 17. The on-state current was 34 μA and the off-state current was 12 pA.

Example 19

(1) Production of semiconductor element

A semiconductor element was produced in the same manner as in Example 17 except that the channel length was 40 μm.

(2) Evaluation as FET

To evaluate the semiconductor element produced above as a FET, measurement was carried out in the same manner as in Example 17. The on-state current was 32 μA and the off-state current was 8 pA.

Example 20

(1) Production of semiconductor element A semiconductor element was produced in the same manner as in Example 17 except that the channel length was 50 μm and the channel width was 10 μm.

(2) Evaluation as FET

To evaluate the semiconductor element produced above as a FET, measurement was carried out in the same

manner as in Example 17. The on-state current was 35 μA and the off-state current was 9 pA.

Example 21

(1) Production of semiconductor element

A semiconductor element was produced in the same manner as in Example 20 except that the channel length was 100 μm.

(2) Evaluation as FET

To evaluate the semiconductor element produced above as a FET, measurement was carried out in the same manner as in Example 17. The on-state current was 30 μA and the off-state current was 8 pA.

Example 22

(1) Production of semiconductor element

A semiconductor element was produced in the same manner as in Example 20 except that the channel length was 200 μm.

(2) Evaluation as FET

To evaluate the semiconductor element produced above as a FET, measurement was carried out in the same manner as in Example 17. The on-state current was 12 μA and the off-state current was 6 pA.

Example 23

(1) Production of semiconductor element

A semiconductor element was produced in the same manner as in Example 20 except that the channel length was 1000 μm and 1200 pL of the semiconductor solution A was dropped.

(2) Evaluation as FET

To evaluate the semiconductor element produced above as a FET, measurement was carried out in the same manner as in Example 17. The on-state current was 10 μA and the off-state current was 5 pA.

Example 24

(1) Production of semiconductor element

A semiconductor element was produced in the same manner as in Example 17 except that the filtration with a membrane filter (pore diameter: 10 μm) was not carried out, the channel length was 20 μm, and the channel width was 15 μm.

(2) Evaluation as FET

To evaluate the semiconductor element produced above as a FET, measurement was carried out in the same manner as in Example 17. The on-state current was 32 μA and the off-state current was 14 pA.

Example 25

(1) Production of semiconductor element

A semiconductor element was produced in the same manner as in Example 24 except that the channel length was 10 μm and the channel width was 7 μm.

(2) Evaluation as FET

To evaluate the semiconductor element produced above as a FET, measurement was carried out in the same manner as in Example 17. The on-state current was 36 μA and the off-state current was 19 pA.

Example 26

(1) Production of semiconductor element

A semiconductor element was produced in the same manner as in Example 24 except that the channel length was 6 μm and the channel width was 4 μm.

(2) Evaluation as FET

To evaluate the semiconductor element produced above as a FET, measurement was carried out in the same manner as in Example 17. The on-state current was 35 μA and the off-state current was 25 pA.

Example 27

(1) Production of semiconductor element

A semiconductor element was produced in the same manner as in Example 17 except that the channel length was 20 μm and the channel width was 10 μm.

(2) Evaluation as FET

To evaluate the semiconductor element produced above as a FET, measurement was carried out in the same manner as in Example 17. The on-state current was 35 μA and the off-state current was 9 pA.

Example 28

(1) Production of semiconductor element

A semiconductor element was produced in the same manner as in Example 27 except that the compound (70) was used instead of P3HT.

(2) Evaluation as FET

To evaluate the semiconductor element produced above as a FET, measurement was carried out in the same manner as in Example 17. The on-state current was 46 μA and the off-state current was 10 pA.

Example 29

(1) Production of semiconductor element

A semiconductor element shown in Fig. 7 was produced. A semiconductor element was produced in the same manner as in Example 27 except that two pairs of electrodes, that is, the first electrode 12 and the first electrode 22, and the second electrode 13 and the second electrode 23 were formed using a different mask pattern from that in Example 27, and two pairs of semiconductor layers, that is, the semiconductor layers 14 and 24, were formed using an inkjet device. The distance between the semiconductor element 10 and the semiconductor element 20 was 20 μm.

(2) Evaluation as FET

To evaluate the semiconductor element produced above as a FET, measurement was carried out in the same manner as in Example 17. The on-state current was 82 μA and the off-state current was 12 pA.

Comparative Example 3

(1) Production of semiconductor element

A semiconductor element was produced in the same manner as in Example 17 except that the channel length was 50 μm and the channel width was 50 μm.

(2) Evaluation as FET

To evaluate the semiconductor element produced above as a FET, measurement was carried out in the same manner as in Example 17. The on-state current was 31 μA and the off-state current was 49 pA.

Comparative Example 4

(1) Production of semiconductor element

A semiconductor element was produced in the same manner as in Example 17 except that the channel length was 25 μm and the channel width was 50 μm.

(2) Evaluation as FET

To evaluate the semiconductor element produced above as a FET, measurement was carried out in the same manner as in Example 17. The on-state current was 32 μA and the off-state current was 75 pA.

The results of the examples and comparative examples are summarized in Tables 1 and 2.

[Table 1]

| | Length of CNTs $L_{CNT}$ [μm] | Channel length $L_C$ [μm] | Channel width $W_C$ [μm] | $L_C/L_{CNT}$ | $W_C/L_C$ | Polymer attached to CNTs | Arithmetic mean roughness (Ra) of substrate [nm] | Element constitution | Biological substance | Sensing target | Decrease in current value [%] | Signal to noise ratio |
|---|---|---|---|---|---|---|---|---|---|---|---|---|
| Example 1 | 1.0 | 250 | 200 | 250 | 0.8 | P3HT | 1.5 | Fig. 4 | Biotin | Avidin | 7.0 | 24 |
| Example 2 | 1.0 | 300 | 200 | 300 | 0.67 | P3HT | 1.5 | Fig. 4 | Biotin | Avidin | 7.1 | 25 |
| Example 3 | 1.0 | 400 | 200 | 400 | 0.5 | P3HT | 1.5 | Fig. 4 | Biotin | Avidin | 8.0 | 30 |
| Example 4 | 1.0 | 1000 | 200 | 1000 | 0.2 | P3HT | 1.5 | Fig. 4 | Biotin | Avidin | 9.0 | 33 |
| Example 5 | 1.0 | 2000 | 200 | 2000 | 0.1 | P3HT | 1.5 | Fig. 4 | Biotin | Avidin | 8.8 | 31 |
| Example 6 | 1.0 | 2000 | 100 | 2000 | 0.05 | P3HT | 1.5 | Fig. 4 | Biotin | Avidin | 7.7 | 15 |
| Example 7 | 1.0 | 2000 | 20 | 2000 | 0.01 | P3HT | 1.5 | Fig. 4 | Biotin | Avidin | 7.1 | 12 |
| Example 8 | 1.0 | 100 | 20 | 100 | 0.2 | P3HT | 1.5 | Fig. 4 | Biotin | Avidin | 8.7 | 32 |
| Example 9 | 2.0 | 100 | 20 | 50 | 0.2 | P3HT | 1.5 | Fig. 4 | Biotin | Avidin | 8.6 | 33 |
| Example 10 | 2.0 | 20 | 15 | 10 | 0.75 | P3HT | 1.5 | Fig. 4 | Biotin | Avidin | 6.5 | 21 |
| Example 11 | 2.0 | 10 | 7 | 5 | 0.7 | P3HT | 1.5 | Fig. 4 | Biotin | Avidin | 6.2 | 20 |
| Example 12 | 2.0 | 6 | 4 | 3 | 0.67 | P3HT | 1.5 | Fig. 4 | Biotin | Avidin | 5.0 | 18 |
| Example 13 | 1.0 | 400 | 200 | 400 | 0.5 | Compound (70) | 1.5 | Fig. 4 | Biotin | Avidin | 8.3 | 33 |
| Example 14 | 1.0 | 400 | 200 | 400 | 0.5 | P3HT | 1.5 | Fig. 4 | IgE aptamer | IgE | 7.9 | 30 |
| Example 15 | 1.0 | 400 | 200 | 400 | 0.5 | P3HT | 1.5 | Fig. 4 | anti-PSA | PSA | 7.8 | 30 |
| Example 16 | 1.0 | 400 | 200 | 400 | 0.5 | P3HT | 1.5 | Fig. 8 | Biotin | Avidin | 9.1 | 38 |
| Comparative Example 1 | 1.0 | 200 | 200 | 200 | 1 | P3HT | 1.5 | Fig. 4 | Biotin | Avidin | 1.5 | 9 |
| Comparative Example 2 | 1.0 | 100 | 200 | 100 | 2 | P3HT | 1.5 | Fig. 4 | Biotin | Avidin | 1.1 | 7 |

[Table 2]

| | Length of CNTs $L_{CNT}$ [μm] | Channel length $L_C$ [μm] | Channel width $W_C$ [μm] | $L_C/L_{CNT}$ | $W_C/L_C$ | Polymer attached to CNTs | Arithmetic mean roughness (Ra) of substrate [nm] | Element constitution | On-state current [μA] | Off-state current [pA] | Degree of integration |
|---|---|---|---|---|---|---|---|---|---|---|---|
| Example 17 | 1.0 | 25 | 20 | 25 | 0.8 | P3HT | 1.5 | Fig. 3 | 33 | 13 | 1600 |
| Example 18 | 1.0 | 30 | 20 | 30 | 0.67 | P3HT | 1.5 | Fig. 3 | 34 | 12 | 1111 |
| Example 19 | 1.0 | 40 | 20 | 40 | 0.5 | P3HT | 1.5 | Fig. 3 | 32 | 8 | 625 |
| Example 20 | 1.0 | 50 | 10 | 50 | 0.2 | P3HT | 1.5 | Fig. 3 | 35 | 9 | 400 |
| Example 21 | 1.0 | 100 | 10 | 100 | 0.1 | P3HT | 1.5 | Fig. 3 | 30 | 8 | 100 |
| Example 22 | 1.0 | 200 | 10 | 200 | 0.05 | P3HT | 1.5 | Fig. 3 | 12 | 6 | 25 |
| Example 23 | 1.0 | 1000 | 10 | 1000 | 0.01 | P3HT | 1.5 | Fig. 3 | 10 | 5 | 1 |
| Example 24 | 2.0 | 20 | 15 | 10 | 0.75 | P3HT | 1.5 | Fig. 3 | 32 | 14 | 2500 |
| Example 25 | 2.0 | 10 | 7 | 5 | 0.7 | P3HT | 1.5 | Fig. 3 | 36 | 19 | 10000 |
| Example 26 | 2.0 | 6 | 4 | 3 | 0.67 | P3HT | 1.5 | Fig. 3 | 35 | 25 | 27778 |
| Example 27 | 1.0 | 20 | 10 | 20 | 0.5 | P3HT | 1.5 | Fig. 3 | 35 | 9 | 2500 |
| Example 28 | 1.0 | 20 | 10 | 20 | 0.5 | Compound (70) | 1.5 | Fig. 3 | 46 | 10 | 2500 |
| Example 29 | 1.0 | 20 | 10 | 20 | 0.5 | P3HT | 1.5 | Fig. 7 | 82 | 12 | 1111 |
| Comparative Example 3 | 1.0 | 50 | 50 | 50 | 1 | P3HT | 1.5 | Fig. 3 | 31 | 49 | 400 |
| Comparative Example 4 | 1.0 | 25 | 50 | 25 | 2 | P3HT | 1.5 | Fig. 3 | 32 | 75 | 400 |

DESCRIPTION OF REFERENCE SIGNS

1: Substrate

2: First electrode

3: Second electrode

4: Semiconductor layer

5: Gate electrode

6: Insulating layer

10: Semiconductor element

12: First electrode of semiconductor element 10

13: Second electrode of semiconductor element 10

14: Semiconductor layer of semiconductor element 10

20: Semiconductor element

22: First electrode of semiconductor element 20

23: Second electrode of semiconductor element 20

24: Semiconductor layer of semiconductor element 20

30: Semiconductor element

32: Electrode that electrically connects first electrode 12 and first electrode 22

33: Electrode that electrically connects second electrode 13 and second electrode 23

50: Antenna

51: Power source generation unit

52: Demodulator circuit

53: Controller circuit

54: Modulator circuit

55: Memory circuit

**Claims**

**1.** A semiconductor element comprising a substrate, a first electrode, a second electrode, and a semiconductor layer disposed between the first electrode and the second electrode, wherein the semiconductor layer contains at least one selected from carbon nanotubes and graphene, and a relationship between a channel length $L_C$ and a channel width $W_C$ of the semiconductor element is $0.01 \leq W_C/L_C \leq 0.8$.

2. The semiconductor element according to claim 1, wherein the relationship is $0.1 \leq W_C/L_C \leq 0.8$.

3. The semiconductor element according to claim 1 or 2, wherein the semiconductor layer contains the carbon nanotubes.

4. The semiconductor element according to any of claims 1 to 3, wherein a relationship between a length $L_{CNT}$ of the carbon nanotubes and the channel length $L_C$ is $5 \leq L_C/L_{CNT}$.

5. The semiconductor element according to any of claims 1 to 4, wherein the carbon nanotubes have a content of metallic carbon nanotubes of 0.5% by weight or more and 10% by weight or less.

6. The semiconductor element according to any of claims 1 to 5, wherein the carbon nanotubes are carbon nanotube composites in which a polymer is attached to at least a part of a surface of the carbon nanotubes.

7. The semiconductor element according to claim 6, wherein the polymer is a conjugated polymer.

8. The semiconductor element according to any of claims 1 to 7, wherein an arithmetic mean roughness (Ra) of a surface of the substrate between the first electrode and the second electrode is 2 nm or less.

9. The semiconductor element according to any of claims 1 to 8, comprising a polysiloxane layer on the substrate.

10. The semiconductor element according to any of claims 1 to 9, wherein $5\ \mu m \leq L_C \leq 30\ \mu m$.

11. The semiconductor element according to any of claims 1 to 10, wherein the semiconductor element is a thin film transistor and further comprises a third electrode and an insulating layer, and the third electrode is disposed electrically insulated from the first electrode, the second electrode, and the semiconductor layer by the insulating layer.

12. A semiconductor element comprising a plurality of the semiconductor elements according to any of claims 1 to 10 as discrete semiconductor elements, wherein the first electrodes in the plurality of discrete semiconductor elements are electrically connected to each other and the second electrodes in the plurality of discrete semiconductor elements are electrically connected to each other.

13. A semiconductor element comprising a plurality of the semiconductor elements according to any of claims 1 to 10 as discrete semiconductor elements, and further comprising a third electrode and an insulating layer, wherein the first electrodes in the plurality of discrete semiconductor elements are electrically connected to each other and the second electrodes in the plurality of discrete semiconductor elements are electrically connected to each other, and the third electrode is disposed electrically insulated from the first electrodes in the plurality of discrete semiconductor elements, the second electrodes in the plurality of discrete semiconductor elements, and the semiconductor layers in the plurality of discrete semiconductor elements by the insulating layer.

14. A wireless communication device comprising at least the semiconductor element according to any of claims 1 to 13 and an antenna.

15. A sensor comprising the semiconductor element according to any of claims 1 to 13.

16. The sensor according to claim 15, comprising, on at least a part of the semiconductor layer, a biological substance that selectively interacts with a sensing target substance.

17. A method for manufacturing the semiconductor element according to any of claims 3 to 13, comprising the step of applying and drying a solution containing carbon nanotubes to form the semiconductor layer.

Fig. 1A

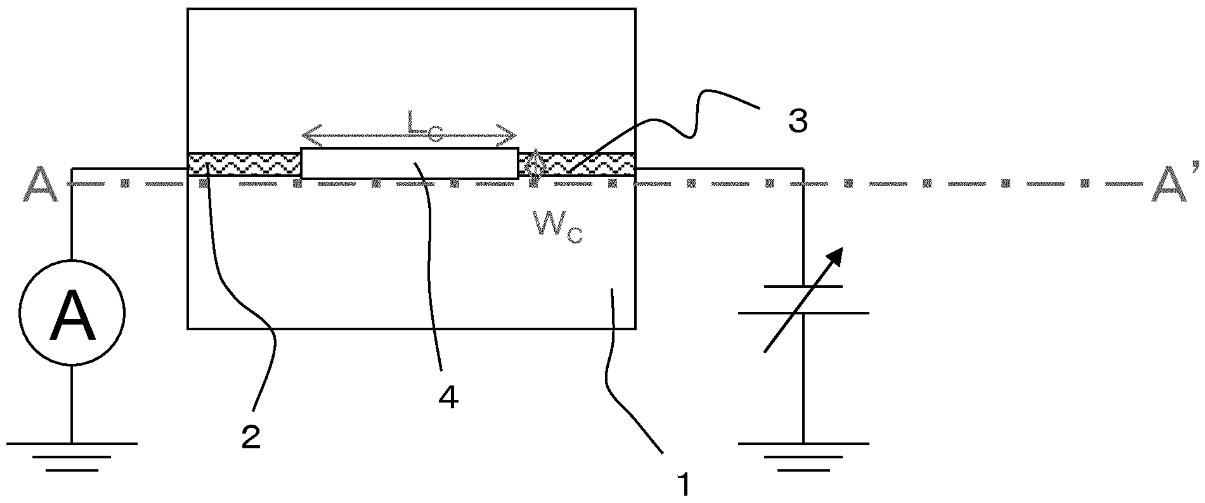


Fig. 1B

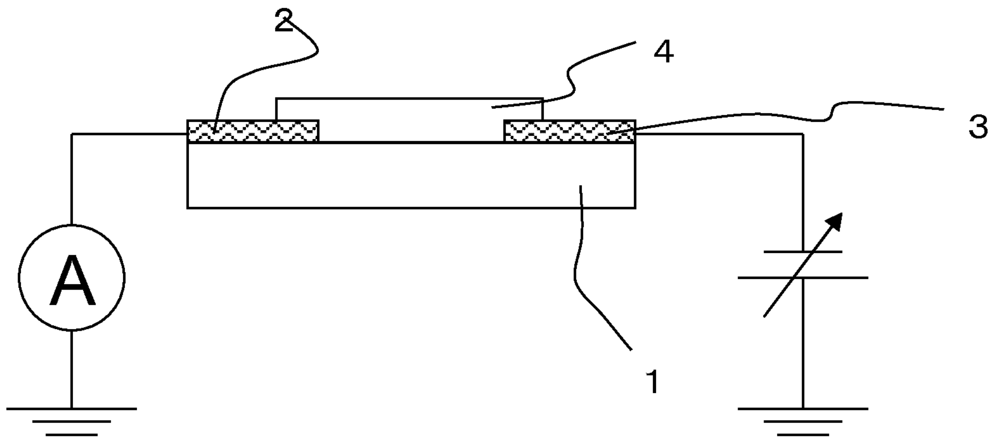

Fig. 2

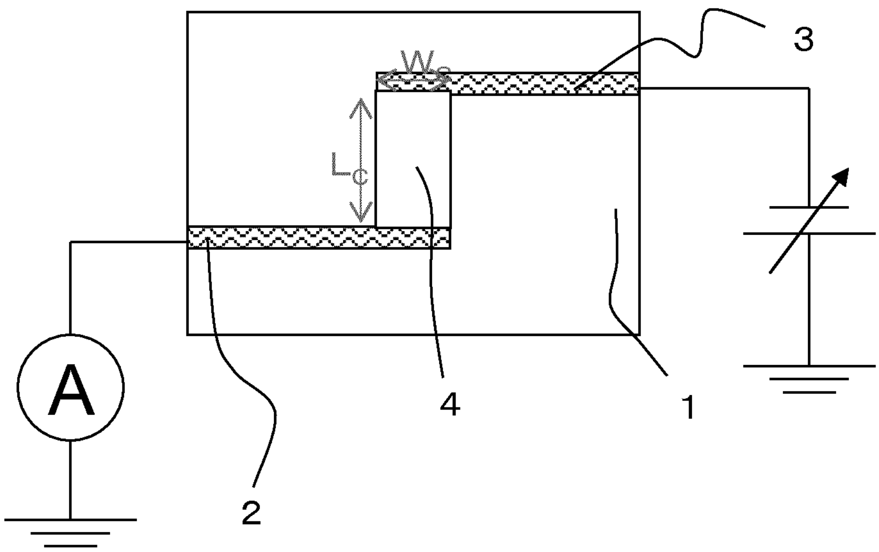


Fig. 3

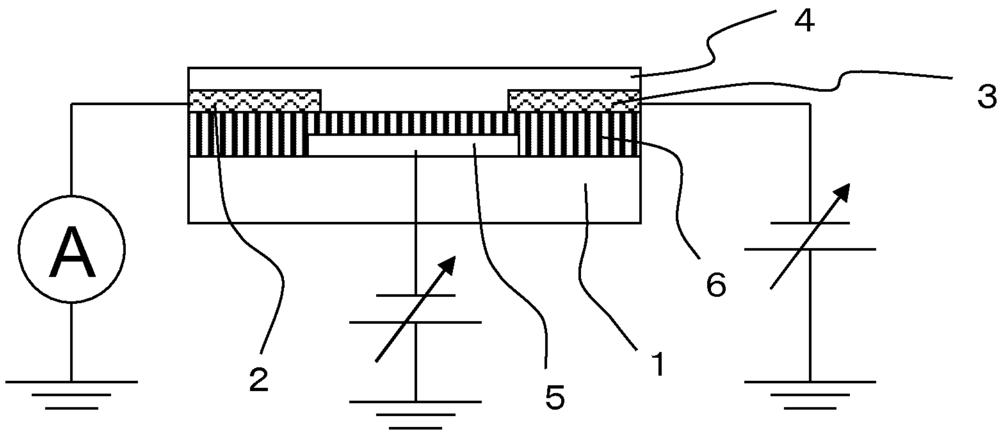

Fig. 4

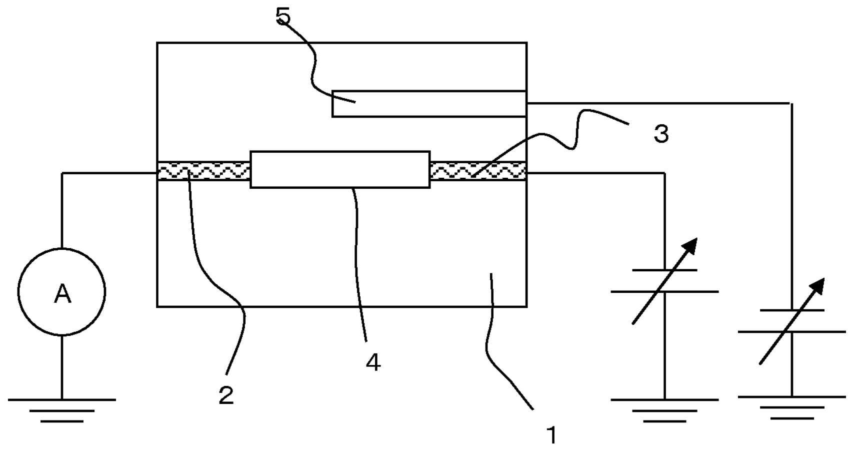
5
3
A
2
4
1

Fig. 5

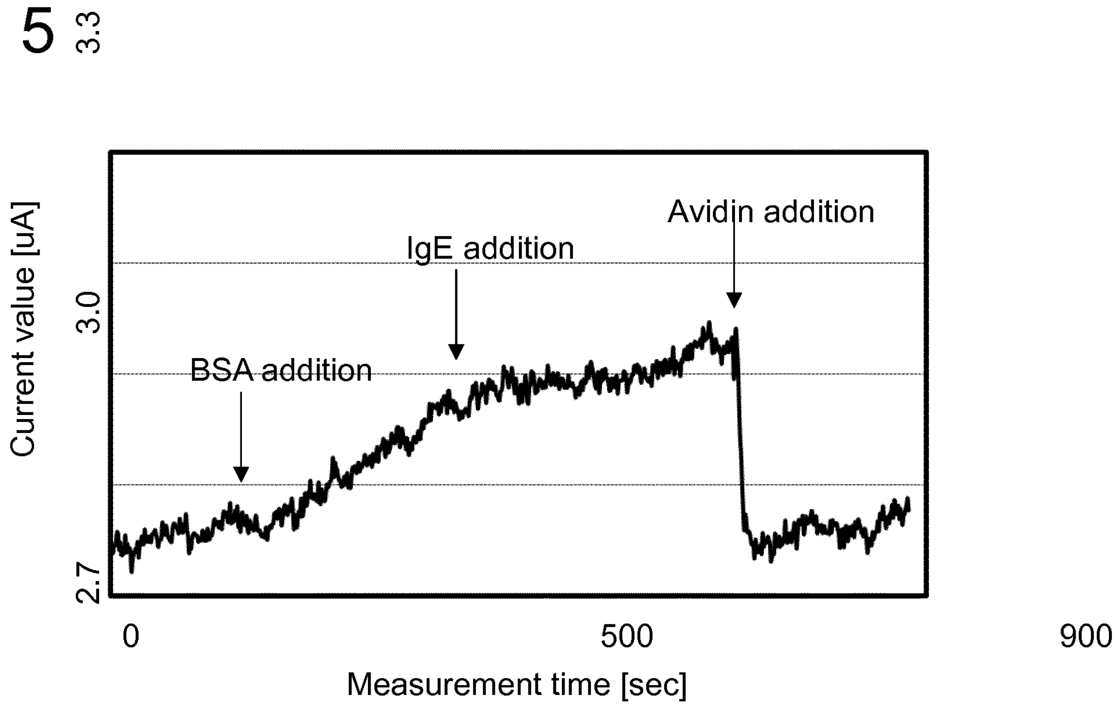
3.3
3.0
2.7
Current value [uA]
Avidin addition
IgE addition
BSA addition
0
500
900
Measurement time [sec]

Fig. 6

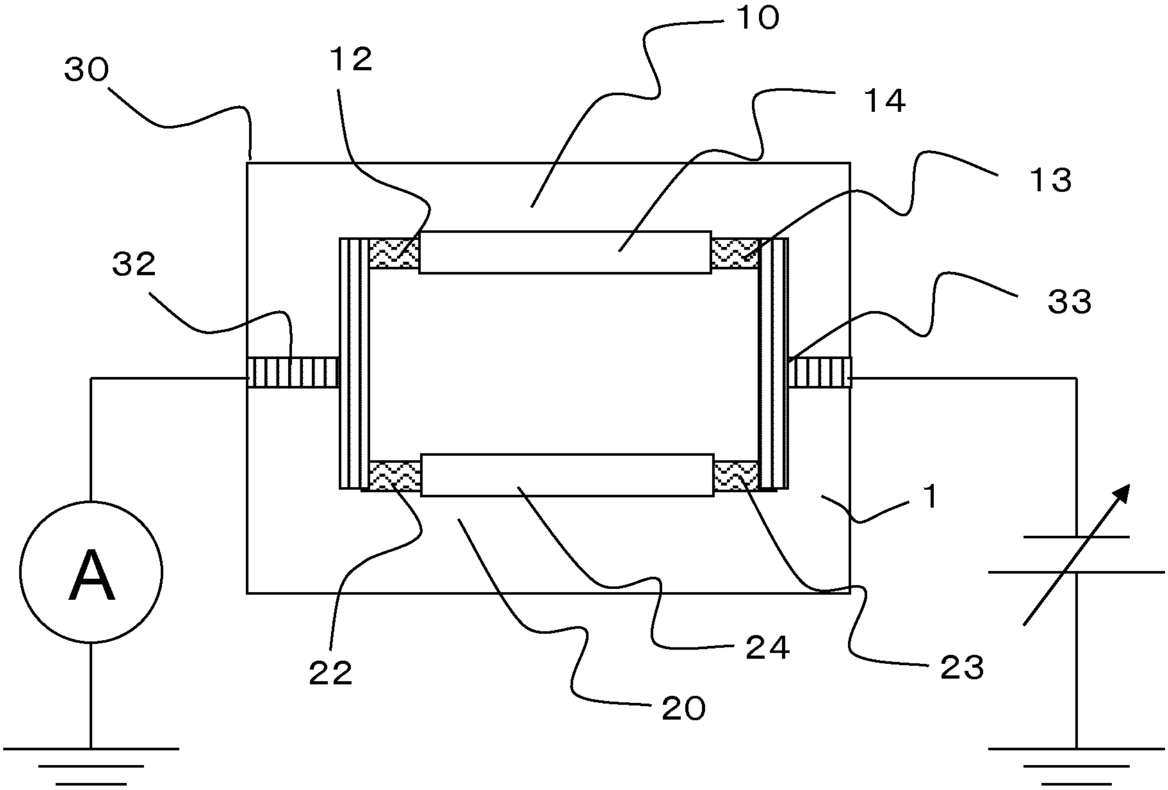

Fig. 7A

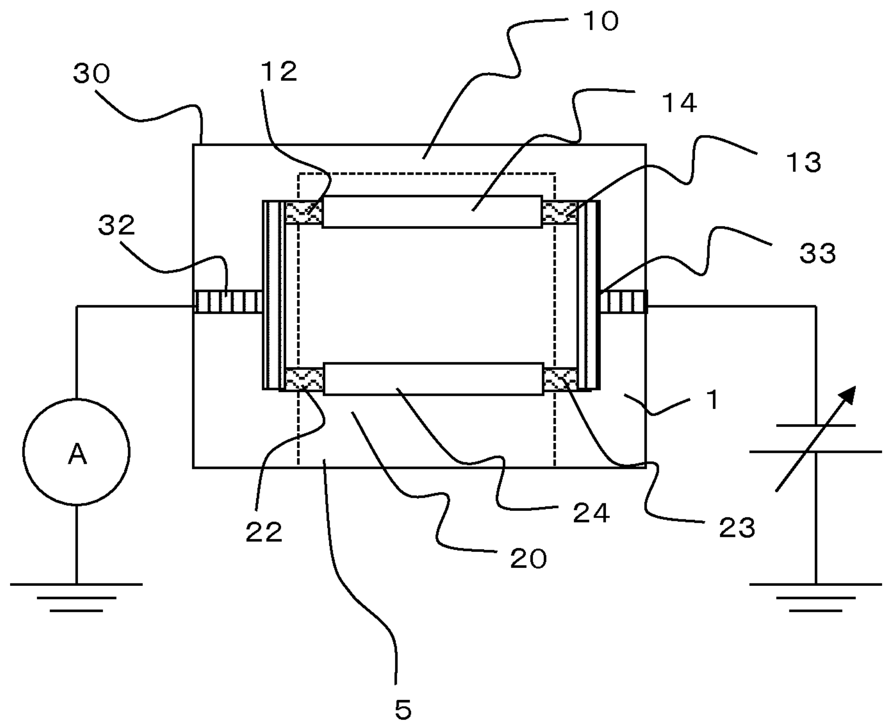


Fig. 7B

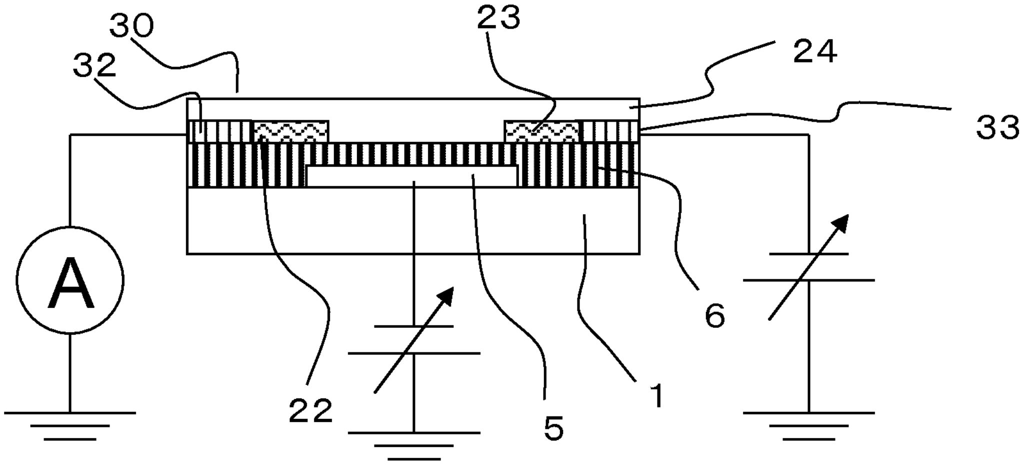

Fig. 8

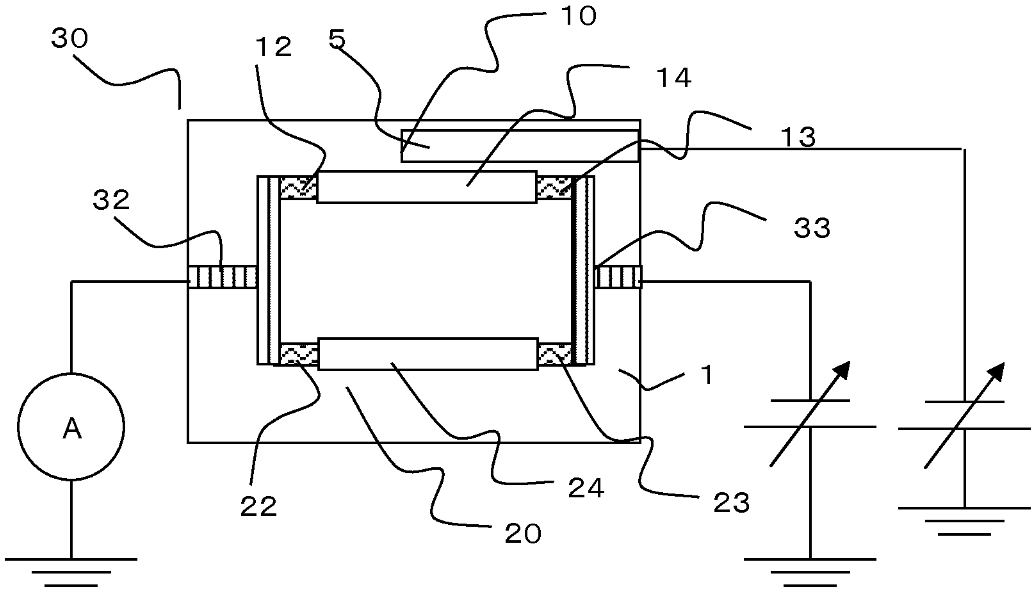


Fig. 9

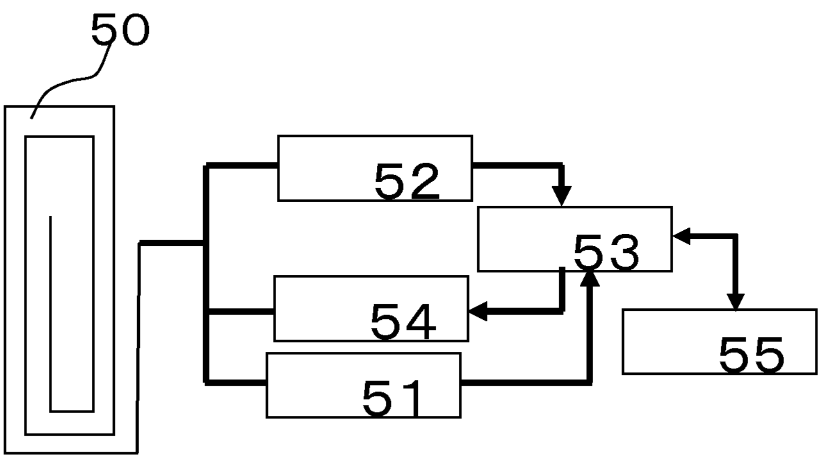

## INTERNATIONAL SEARCH REPORT

International application No. PCT/JP2017/014961

A. CLASSIFICATION OF SUBJECT MATTER
*H01L51/05*(2006.01)i, *G01N27/414*(2006.01)i, *H01L51/30*(2006.01)i

According to International Patent Classification (IPC) or to both national classification and IPC

B. FIELDS SEARCHED

Minimum documentation searched (classification system followed by classification symbols)
H01L51/05, G01N27/414, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2015/012186 A1 (Toray Industries, Inc.), 29 January 2015 (29.01.2015), paragraphs [0015] to [0122]; fig. 1 to 5 & US 2016/0155948 A1 paragraphs [0022] to [0133]; fig. 1 to 5 & EP 3026014 A1 & CN 105408245 A & KR 10-2016-0033118 A & TW 201505961 A | 1-17 |
| A | JP 2009-239178 A (NEC Corp.), 15 October 2009 (15.10.2009), paragraphs [0017] to [0149]; fig. 1 to 10 (Family: none) | 1-17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 July 2017 (04.07.17) | 11 July 2017 (11.07.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/014961

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-531449 A (Motorola, Inc.), 14 August 2008 (14.08.2008), paragraphs [0008] to [0016]; fig. 1 to 8 & US 2006/0194058 A1 paragraphs [0015] to [0024]; fig. 1 to 8 & WO 2006/093601 A2 & EP 1851806 A1 & CN 101390218 A | 1-17 |
| A | JP 2011-61046 A (Sony Corp.), 24 March 2011 (24.03.2011), paragraphs [0014] to [0070]; fig. 1 to 7 & US 2011/0057168 A1 paragraphs [0028] to [0144]; fig. 1 to 7 & CN 102024846 A | 1-17 |
| P,A | WO 2017/026439 A1 (Toray Industries, Inc.), 16 February 2017 (16.02.2017), paragraphs [0012] to [0147]; fig. 1 to 4 & TW 201706599 A | 1-17 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2009139339 A
- JP 2012163578 A
- WO 2015012186 A


### Non-patent literature cited in the description


- *ANALYTICAL CHEMISTRY,* 2007, vol. 79, 782-787
- *ACS NANO,* 2010, vol. 4 (11), 6914-6922